(19) Europäisches Patentamt
European Patent Office
Office européen des brevets

(11) EP 4 429 120 A1

(12) **EUROPEAN PATENT APPLICATION**
published in accordance with Art. 153(4) EPC

(43) Date of publication:
**11.09.2024 Bulletin 2024/37**

(21) Application number: **22889806.0**

(22) Date of filing: **21.10.2022**

(51) International Patent Classification (IPC):
***H03M 13/19*** *(2006.01)* ***H04L 27/26*** *(2006.01)*

(52) Cooperative Patent Classification (CPC):
**H03M 13/19; H04L 27/26**

(86) International application number:
**PCT/JP2022/039359**

(87) International publication number:
**WO 2023/079986 (11.05.2023 Gazette 2023/19)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.11.2021 JP 2021179128**

(71) Applicant: **Sony Group Corporation**
**Tokyo**
**108-0075 (JP)**

(72) Inventors:
- **SHINOHARA Yuji**
  **Tokyo 108-0075 (JP)**
- **YAMAMOTO Makiko**
  **Tokyo 108-0075 (JP)**

(74) Representative: **2SPL Patentanwälte PartG mbB**
**Landaubogen 3**
**81373 München (DE)**

(54) **TRANSMISSION DEVICE, TRANSMISSION METHOD, RECEPTION DEVICE, AND RECEPTION METHOD**

(57) The present technology relates to a transmission device, a transmission method, a reception device, and a reception method capable of ensuring good communication quality in data transmission using an LDPC code.

The LDPC coding is performed on the basis of the parity check matrix of the LDPC code with the code length N of 1224 or 1152 bits and the coding rate r of 144/1224 or 144/1152. The parity check matrix includes an A matrix of M1 rows and K columns represented by a predetermined value M1 and an information length K = N × r of the LDPC code, a B matrix of a staircase structure of M1 rows and M1 columns, a Z matrix which is a zero matrix of M1 rows and N - K - M1 columns, a C matrix of N - K - M1 rows and K + M1 columns, and a D matrix which is an identity matrix of N - K - M1 rows and N - K - M1 columns. The A matrix and the C matrix are represented by a parity check matrix initial value table, and the parity check matrix initial value table is a table representing the positions of the elements of 1 of the A matrix and the C matrix for every 36 columns, and is a predetermined table. The present technology can be applied to, for example, data transmission using an LDPC code.

*FIG. 10*

M
K
M1
M2=N−K−M1
A
B
Z
C
D
M=N−K
M1
M2



Processed by Luminess, 75001 PARIS (FR)

**Description**

TECHNICAL FIELD

The present technology relates to a transmission device, a transmission method, a reception device, and a reception method, and more particularly, to a transmission device, a transmission method, a reception device, and a reception method capable of ensuring good communication quality in data transmission using, for example, an LDPC code.

BACKGROUND ART

Low density parity check (LDPC) codes have high error correction capability, and in recent years, for example, have been widely adopted in transmission systems of digital broadcasting and the like such as digital video broadcasting (DVB)-S.2, DVB-T.2, and DVB-C.2 in Europe and the like, and advanced television systems committee (ATSC)3.0 in the United States and the like (Non-Patent Document 1).

CITATION LIST

NON-PATENT DOCUMENT

Non-Patent Document 1: ATSC Standard: Physical Layer Protocol (A/322), 7 September 2016

SUMMARY OF THE INVENTION

PROBLEMS TO BE SOLVED BY THE INVENTION

In data transmission using the LDPC code, for example, the LDPC code is used as a symbol of quadrature modulation (digital modulation) such as quadrature phase shift keying (QPSK) (symbolized), and the symbol is mapped to a signal point of the quadrature modulation and transmitted.

Data transmission using the LDPC code as described above is spreading worldwide, and it is required to ensure good communication (transmission) quality.

The present technology has been made in view of such a situation, and aims to ensure good communication quality in data transmission using the LDPC code.

SOLUTIONS TO PROBLEMS

A first transmission device/method of the present technology includes an encoding unit/step of performing LDPC coding on the basis of a parity check matrix of an LDPC code with a code length N of 1224 bits and a coding rate r of 144/1224, in which the parity check matrix includes: an A matrix on an upper left of the parity check matrix, of M1 rows and K columns represented by a predetermined value M1 and an information length K = N × r of the LDPC code; a B matrix of a staircase structure adjacent to a right of the A matrix, of M1 rows and M1 columns; a Z matrix that is a zero matrix adjacent to a right of the B matrix, of M1 rows and N - K - M1 columns; a C matrix adjacent under the A matrix and the B matrix, of N - K - M1 rows and K + M1 columns; and a D matrix that is an identity matrix adjacent to a right of the C matrix, of N - K - M1 rows and N - K - M1 columns, the predetermined value M1 is 108, the A matrix and the C matrix are represented by a parity check matrix initial value table, the parity check matrix initial value table is a table representing positions of elements of 1 of the A matrix and the C matrix for every 36 columns, and

7 36 107 167 173 350 489 510 577 643 716 789 960 979 1061 1076
53 75 103 336 349 396 414 480 488 490 513 559 610 622 827 1039
13 69 101 108 122 277 483 532 546 587 612 710 713 858 982 1025
10 32 72 282 420 441 482 553 784 808 977
139 178 778 803 813 1055
130 576 709 732 827 991
109 125 403 905 998 1068.

A first reception device/method of the present technology includes a decoding unit/step of decoding an LDPC code obtained from data transmitted by a transmission method including an encoding step of performing LDPC coding on the basis of a parity check matrix of the LDPC code with a code length N of 1224 bits and a coding rate r of 144/1224, in which the parity check matrix includes: an A matrix on an upper left of the parity check matrix, of M1 rows and K columns represented by a predetermined value M1 and an information length K = N × r of the LDPC code; a B matrix of a staircase structure adjacent to a right of the A matrix, of M1 rows and M1 columns; a Z matrix that is a zero matrix adjacent to a right of the B matrix, of M1 rows and N - K - M1 columns; a C matrix adjacent under the A matrix and the B matrix, of N - K - M1 rows and K + M1 columns; and a D matrix that is an identity matrix adjacent to a right of the C matrix, of N - K - M1 rows and N - K - M1 columns, the predetermined value M1 is 108, the A matrix and the C matrix are represented by a parity check matrix initial value table, the parity check matrix initial value table is a table representing positions of elements of 1 of the A matrix and the C matrix for every 36 columns, and

7 36 107 167 173 350 489 510 577 643 716 789 960 979 1061 1076
53 75 103 336 349 396 414 480 488 490 513 559 610 622 827 1039
13 69 101 108 122 277 483 532 546 587 612 710 713 858 982 1025
10 32 72 282 420 441 482 553 784 808 977
139 178 778 803 813 1055
130 576 709 732 827 991
109 125 403 905 998 1068.

A second transmission device/method of the present technology includes an encoding unit/step of performing LDPC coding on the basis of a parity check matrix of an LDPC code with a code length N of 1152 bits and a coding rate r of 144/1152, in which the parity check matrix includes: an A matrix on an upper left of the parity check matrix, of M1 rows and K columns represented by a predetermined value M1 and an information length K = N × r of the LDPC code; a B matrix of a staircase structure adjacent to a right of the A matrix, of M1 rows and M1 columns; a Z matrix that is a zero matrix adjacent to a right of the B matrix, of M1 rows and N - K - M1 columns; a C matrix adjacent under the A matrix and the B matrix, of N - K - M1 rows and K + M1 columns; and a D matrix that is an identity matrix adjacent to a right of the C matrix, of N - K - M1 rows and N - K - M1 columns, the predetermined value M1 is 144, the A matrix and the C matrix are represented by a parity check matrix initial value table, the parity check matrix initial value table is a table representing positions of elements of 1 of the A matrix and the C matrix for every 36 columns, and

9 70 143 150 170 202 349 475 620 732 806 1005
11 72 77 201 220 258 389 431 680 761 958
12 47 142 193 195 279 496 552 587 703 871
24 41 66 213 352 427 589 647 738 824 845
153 639 860 892 984
314 377 470 803 994
147 342 721 732 766
206 415 670 749 778.

A second reception device/method of the present technology includes a decoding unit/step of decoding an LDPC code obtained from data transmitted by a transmission method including an encoding step of performing LDPC coding on the basis of a parity check matrix of the LDPC code with a code length N of 1152 bits and a coding rate r of 144/1152, in which the parity check matrix includes: an A matrix on an upper left of the parity check matrix, of M1 rows and K columns represented by a predetermined value M1 and an information length K = N × r of the LDPC code; a B matrix of a staircase structure adjacent to a right of the A matrix, of M1 rows and M1 columns; a Z matrix that is a zero matrix adjacent to a right of the B matrix, of M1 rows and N - K - M1 columns; a C matrix adjacent under the A matrix and the B matrix, of N - K - M1 rows and K + M1 columns; and a D matrix that is an identity matrix adjacent to a right of the C matrix, of N - K - M1 rows and N - K - M1 columns, the predetermined value M1 is 144, the A matrix and the C matrix are represented by a parity check matrix initial value table, the parity check matrix initial value table is a table representing positions of elements of 1 of the A matrix and the C matrix for every 36 columns, and

9 70 143 150 170 202 349 475 620 732 806 1005
11 72 77 201 220 258 389 431 680 761 958
12 47 142 193 195 279 496 552 587 703 871
24 41 66 213 352 427 589 647 738 824 845
153 639 860 892 984
314 377 470 803 994
147 342 721 732 766
206 415 670 749 778.

In the first transmission device/method of the present technology, the LDPC coding is performed on the basis of the parity check matrix of the LDPC code with the code length N of 1224 bits and the coding rate r of 144/1224. The parity check matrix includes: an A matrix on an upper left of the parity check matrix, of M1 rows and K columns represented by a predetermined value M1 and an information length K = N × r of the LDPC code; a B matrix of a staircase structure adjacent to a right of the A matrix, of M1 rows and M1 columns; a Z matrix that is a zero matrix adjacent to a right of the B matrix, of M1 rows and N - K - M1 columns; a C matrix adjacent under the A matrix and the B matrix, of N - K - M1 rows and K + M1 columns; and a D matrix that is an identity matrix adjacent to a right of the C matrix, of N - K - M1 rows and N - K - M1 columns, the predetermined value M1 is 108, the A matrix and the C matrix are represented by a parity check matrix initial value table, the parity check matrix initial value table is a table representing positions of elements of 1 of the A matrix and the C matrix for every 36 columns, and

7 36 107 167 173 350 489 510 577 643 716 789 960 979 1061 1076
53 75 103 336 349 396 414 480 488 490 513 559 610 622 827 1039
13 69 101 108 122 277 483 532 546 587 612 710 713 858 982 1025
10 32 72 282 420 441 482 553 784 808 977
139 178 778 803 813 1055
130 576 709 732 827 991
109 125 403 905 998 1068.

In the first reception device/method of the present technology, the LDPC code obtained from the data transmitted by the first transmission method is decoded.

In the second transmission device/method of the present technology, the LDPC coding is performed on the basis of the parity check matrix of the LDPC code with the code length N of 1152 bits and the coding rate r of 144/1152. The parity check matrix includes: an A matrix on an upper left of the parity check matrix, of M1 rows and K columns represented by a predetermined value M1 and an information length K = N × r of the LDPC code; a B matrix of a staircase structure adjacent to a right of the A matrix, of M1 rows and M1 columns; a Z matrix that is a zero matrix adjacent to a right of the B matrix, of M1 rows and N - K - M1 columns; a C matrix adjacent under the A matrix and the B matrix, of N - K - M1 rows and K + M1 columns; and a D matrix that is an identity matrix adjacent to a right of the C matrix, of N - K - M1 rows and N - K - M1 columns, the predetermined value M1 is 144, the A matrix and the C matrix are represented by a parity check matrix initial value table, the parity check matrix initial value table is a table representing positions of elements of 1 of the A matrix and the C matrix for every 36 columns, and

9 70 143 150 170 202 349 475 620 732 806 1005
11 72 77 201 220 258 389 431 680 761 958
12 47 142 193 195 279 496 552 587 703 871
24 41 66 213 352 427 589 647 738 824 845
153 639 860 892 984
314 377 470 803 994
147 342 721 732 766
206 415 670 749 778.

In the second reception device/method of the present technology, the LDPC code obtained from the data transmitted by the second transmission method is decoded.

Note that the transmission device and the reception device may be independent devices or internal blocks constituting one device. In addition, the transmission device and the reception device can be configured by a semiconductor chip of one chip or a plurality of chips.

Some or all of the transmission device and the reception device can be functionally realized by causing a computer to execute a program. The program can be provided by transmitting via a transmission medium or by recording on a recording medium.

BRIEF DESCRIPTION OF DRAWINGS

Fig. 1 is a diagram illustrating a configuration example of an embodiment of a transmission system to which the present technology is applied.
Fig. 2 is a block diagram illustrating a configuration example of a transmission device 11.
Fig. 3 is a diagram illustrating a configuration example of an OFDM signal generated by an OFDM signal generation unit 23.

Fig. 4 is a diagram illustrating an example of a parity check matrix.

Fig. 5 is a diagram illustrating an example of a parity matrix.

Fig. 6 is a diagram for explaining a parity check matrix of an LDPC code defined in the DVB-T.2 standard.

Fig. 7 is a flowchart for explaining an example of processing of a transmission device 11.

Fig. 8 is a flowchart for explaining an example of processing of an encoding unit 21.

Fig. 9 is a diagram for explaining a method of obtaining a parity check matrix H from a parity check matrix initial value table.

Fig. 10 is a diagram illustrating a structure of a parity check matrix.

Fig. 11 is a diagram illustrating an example of a parity check matrix initial value table.

Fig. 12 is a diagram for explaining an A matrix generated from a parity check matrix initial value table.

Fig. 13 is a diagram for explaining parity interleaving for a B matrix.

Fig. 14 is a diagram for explaining a C matrix generated from a parity check matrix initial value table.

Fig. 15 is a diagram for explaining parity interleaving of a D matrix.

Fig. 16 is a diagram illustrating a parity check matrix on which column permutation as parity deinterleaving for restoring parity interleaving is performed.

Fig. 17 is a diagram illustrating a transformed parity check matrix obtained by performing row permutation for a parity check matrix.

Fig. 18 is a diagram illustrating a first example of a parity check matrix initial value table of a new LDPC code.

Fig. 19 is a diagram illustrating a second example of a parity check matrix initial value table of a new LDPC code.

Fig. 20 is a diagram illustrating an example of a Tanner graph of an ensemble of degree sequence having a column weight of 3 and a row weight of 6.

Fig. 21 is a diagram illustrating an example of a Tanner graph of a multi edge type ensemble.

Fig. 22 is a diagram for explaining a parity check matrix by a type A method.

Fig. 23 is a diagram illustrating parameters of a type A code.

Fig. 24 is a diagram for explaining a simulation method for evaluating performance of a new LDPC code.

Fig. 25 is a diagram illustrating a simulation result of FER in a case where a new LDPC code with a coding rate r = 144/1224 is used.

Fig. 26 is a diagram illustrating a simulation result of FER in a case where a new LDPC code with a coding rate r = 144/1152 is used.

Fig. 27 is a block diagram illustrating a configuration example of a reception device 12.

Fig. 28 is a flowchart for explaining an example of processing of the reception device 12.

Fig. 29 is a diagram illustrating an example of a parity check matrix of an LDPC code.

Fig. 30 is a diagram illustrating an example of a matrix (transformed parity check matrix) obtained by applying row permutation and column permutation to a parity check matrix.

Fig. 31 is a diagram illustrating an example of a transformed parity check matrix divided into 5 $\times$ 5 units.

Fig. 32 is a block diagram illustrating a configuration example of a decoding device that collectively performs P node operations.

Fig. 33 is a block diagram illustrating a configuration example of a decoding unit 64.

Fig. 34 is a block diagram illustrating a configuration example of an embodiment of a computer to which the present technology is applied.

MODE FOR CARRYING OUT THE INVENTION

<Configuration Example of Transmission System to Which Present Technology Is Applied>

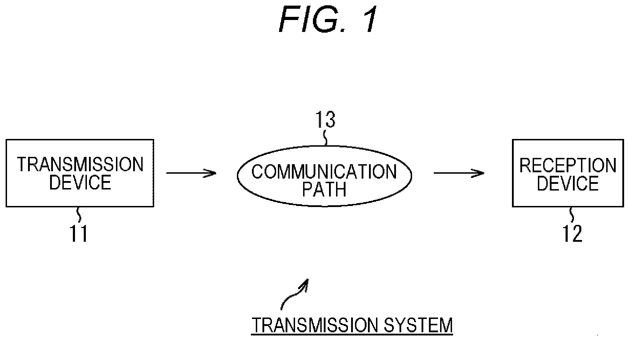

Fig. 1 is a diagram illustrating a configuration example of an embodiment of a transmission system (the system refers to a logical assembly of a plurality of devices, and it does not matter whether or not the devices of each configuration are in the same housing) to which the present technology is applied.

In Fig. 1, the transmission system includes a transmission device 11 and a reception device 12.

The transmission device 11 transmits (broadcasts) a television broadcast program or the like, for example. That is, the transmission device 11 encodes target data to be transmitted, such as image data or audio data as a program, for example, into an LDPC code, and transmits the LDPC code via the communication path 13 such as a satellite line, a ground wave, or a cable (wired line), for example.

The reception device 12 receives the LDPC code transmitted from the transmission device 11 via the communication path 13, decodes the LDPC code into target data, and outputs the target data.

Hereinafter, in the transmission system of Fig. 1, it is assumed that information is transmitted by the terrestrial broadcasting advanced method except for matters to be particularly mentioned. However, the transmission method to which the present technology is applied is not limited to the terrestrial broadcasting advanced method.

<Configuration Example of Transmission Device 11>

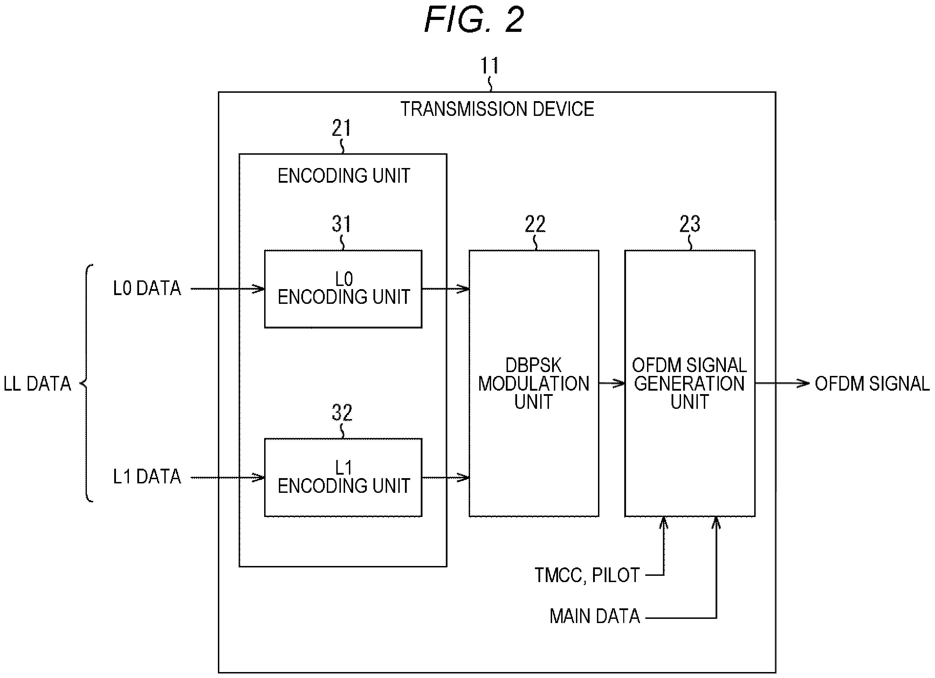

Fig. 2 is a block diagram illustrating a configuration example of the transmission device 11 in Fig. 1.

In Fig. 2, the transmission device 11 includes an encoding unit 21, a differential binary phase shift keying (DBPSK) modulation unit 22, and an OFDM signal generation unit 23.

LL data which is data transmitted in a low latency transmission channel (hereinafter, also referred to as LLch) for performing low latency transmission is supplied to the encoding unit 21.

The LL data includes L0 data transmitted in a channel (LOch) within a partial reception band in which partial reception is possible and L1 data transmitted in a channel (L1ch) in a band other than the partial reception band in a frequency band allocated to one channel in which the transmission device 11 transmits the OFDM signal.

As the LL data, emergency information such as earthquake early warning and other information requiring low latency transmission can be adopted.

Among the LL data, the L0 data transmitted through the channel (LOch) in the partial reception band is superior in promptly reporting performance to the L1 data transmitted through the channel (L1ch) in the band other than the partial reception band. Therefore, the L0 data is useful, for example, in a case where a disaster occurs, for transmission of particularly urgent information such as the occurrence of the disaster itself or the type of the disaster.

The encoding unit 21 includes an L0 encoding unit 31 and an L1 encoding unit 32.

Among the LL data supplied to the encoding unit 21, the L0 data is supplied to the L0 encoding unit 31, and the L1 data is supplied to the L1 encoding unit 32.

The L0 encoding unit 31 sets the L0 data supplied thereto as LDPC target data to be LDPC encoded, performs, for the LDPC target data, LDPC coding according to a predetermined parity check matrix such as a parity check matrix in which (a part or all of) a parity matrix that is a portion corresponding to parity bits of the LDPC code has a staircase (dual diagonal) structure, and outputs an LDPC code having the LDPC target data as information bits, for example.

Similarly to the L0 encoding unit 31, the L1 encoding unit 32 sets the L1 data supplied thereto as LDPC target data to be subjected to LDPC coding, performs LDPC coding according to a predetermined parity check matrix for the LDPC target data, and outputs an LDPC code having the LDPC target data as information bits.

The parity check matrices used for the LDPC coding of the L0 encoding unit 31 and the L1 encoding unit 32 may be different from each other or may be the same.

As the LDPC code obtained as a result of the LDPC coding in the L0 encoding unit 31 and the L1 encoding unit 32, for example, an irregular repeat accumulate (IRA) code can be adopted similarly to the LDPC code defined in the standard such as DVB-S.2 or ATSC 3.0.

The LDPC codes output from the L0 encoding unit 31 and the L1 encoding unit 32 are supplied to the DBPSK modulation unit 22.

The DBPSK modulation unit 22 performs DBPSK modulation (mapping corresponding to) of each of the LDPC codes from the L0 encoding unit 31 and the L1 encoding unit 32, and outputs carriers (signal points on the IQ constellation) of the LDPC codes of the L0 data and the L1 data obtained as a result.

Hereinafter, the carriers of the LDPC codes of the L0 data and the L1 data are also referred to as an L0 carrier and an L1 carrier, respectively.

The L0 carrier and the L1 carrier output from the DBPSK modulation unit 22 are supplied to the OFDM signal generation unit 23.

In addition to the L0 carrier and the L1 carrier from the DBPSK modulation unit 22, a transmission and multiplexing configulation control (TMCC) carrier of TMCC information, a pilot carrier of a pilot signal, a main data carrier of each layer data (main data) such as the A layer to the C layer, and the like are supplied from a circuit not illustrated to the OFDM signal generation unit 23.

The OFDM signal generation unit 23 configures an OFDM frame including an L0 carrier, an L1 carrier, a TMCC carrier, a pilot carrier, a main data carrier, and the like, and generates an OFDM signal by performing inverse fast Fourier transform (IFFT) and addition of a guard interval (GI).

In the transmission device 11, the OFDM signal generated by the OFDM signal generation unit 23 is transmitted.

<Configuration Example of OFDM Signal>

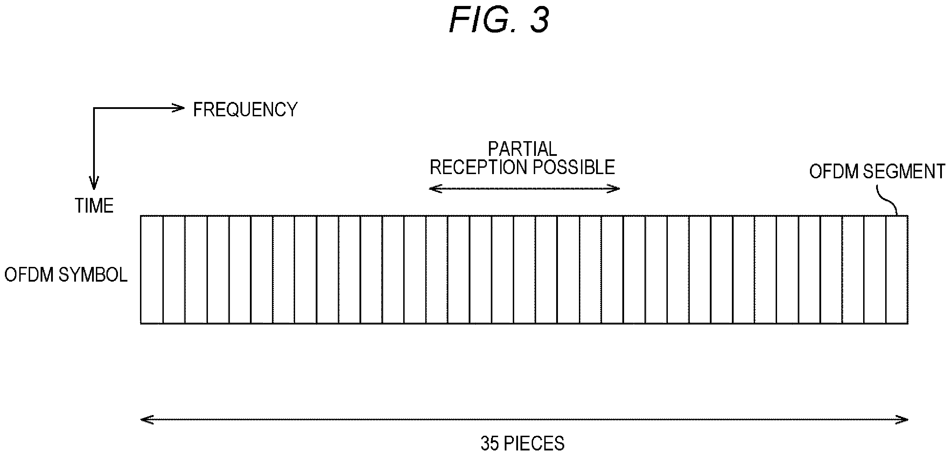

Fig. 3 is a diagram illustrating a configuration example of an OFDM signal generated by the OFDM signal generation unit 23.

The OFDM signal includes units called OFDM symbols arranged in a time direction.

The OFDM symbol is a unit of IFFT, and for example, 35 OFDM segments as a plurality of OFDM symbols are arranged in the frequency direction.

Fig. 3 illustrates a configuration example of OFDM symbols constituting an OFDM signal.

In the terrestrial broadcasting advanced method, a frequency band allocated to one channel for transmitting an OFDM signal is divided into 36, and 35 OFDM segments constituting an OFDM symbol are transmitted by 35 segments among 36 segments (frequency bands) after the division.

Among the 35 OFDM segments, the middle 9 OFDM segments are partially receivable OFDM segments, that is, OFDM segments in which information can be restored only by receiving the 9 OFDM segments. The segment (band) in which the central nine OFDM segments that can be partially received are transmitted is the partial reception band.

An arbitrary number of OFDM segments in a range from one to nine OFDM segments among the nine central OFDM segments that can be partially received can be set in the A layer and used for mobile reception or the like.

In the OFDM signal generation unit 23, the L0 carriers are arranged in the middle nine OFDM segments that can be partially received, and the L1 carriers are arranged in the 26 (= 35 - 9) OFDM segments other than the partially receivable OFDM segments.

For example, eight L0 carriers can be arranged in each partially receivable OFDM segment.

In a case where eight L0 carriers are arranged in each of the nine middle OFDM segments that can be partially received, 72 (= 9 * 8) L0 carriers are arranged in one OFDM symbol.

As the 72 L0 carriers arranged in one OFDM symbol, different L0 carriers can be adopted, or the same L0 carrier can be adopted in units of a plurality of L0 carriers.

In a case where different L0 carriers are all adopted as the 72 L0 carriers, 72 bits can be transmitted with one OFDM symbol.

For example, in a case where the same L0 carrier is adopted in units of two as the 72 L0 carriers, only 36 bits can be transmitted in one OFDM symbol, but resistance to an error can be improved.

<Outline of Parity Check Matrix of LDPC Code>

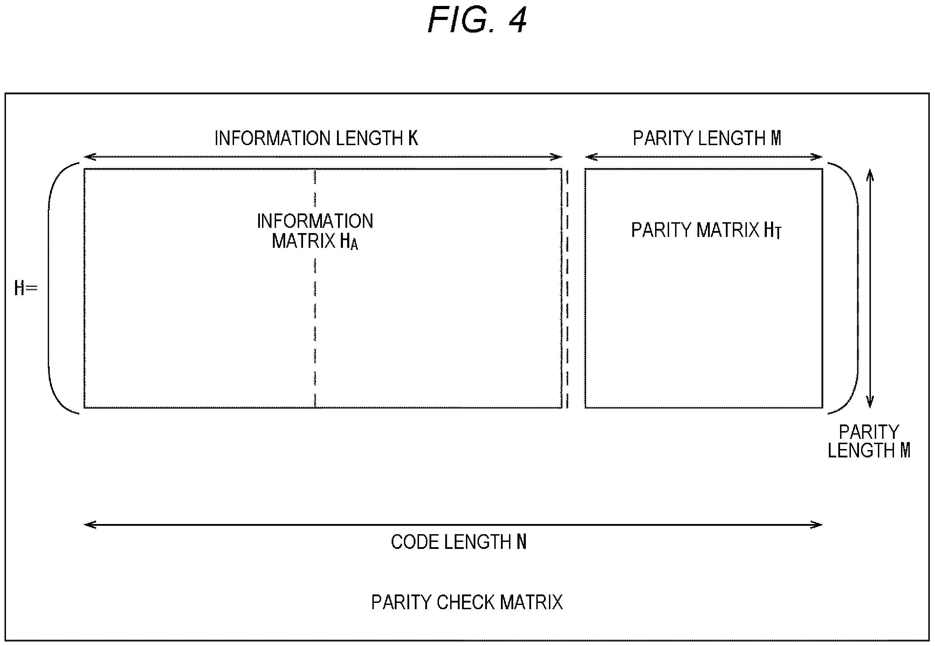

Fig. 4 is a diagram illustrating an example of a parity check matrix H used for LDPC coding in the encoding unit 21 in Fig. 2.

The parity check matrix H has a low-density generation matrix (LDGM) structure, and can be expressed by an equation $H = [H_A|H_T]$ (a matrix in which elements of the information matrix $H_A$ are elements on the left side and elements of the parity matrix $H_T$ are elements on the right side) by an information matrix $H_A$ of a portion corresponding to the information bits and the parity matrix $H_T$ corresponding to the parity bits among the sign bits of the LDPC code.

Here, the length of information bits and the length of parity bits among the sign bits of one LDPC code (one code word) are referred to as an information length K and a parity length M, respectively, and the length of sign bits of one (one code word) LDPC code is referred to as a code length N (= K + M).

The coding rate r of the LDPC code with the code length N is expressed by an equation $r = K/(K + M) = K/N$. Furthermore, the parity check matrix H is a matrix having $M \times N$ rows and columns (a matrix of M rows and N columns). In the parity check matrix H, the information matrix $H_A$ is an $M \times K$ matrix, and the parity matrix $H_T$ is an $M \times M$ matrix.

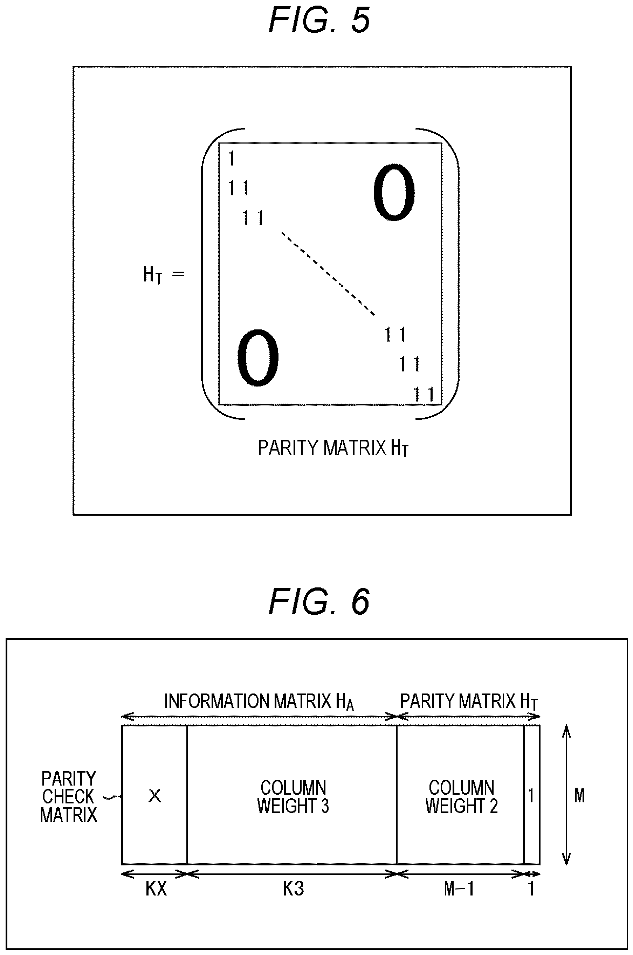

Fig. 5 is a diagram illustrating an example of the parity matrix $H_T$ of the parity check matrix H used for LDPC coding in the encoding unit 21 in Fig. 2.

As the parity matrix $H_T$ of the parity check matrix H used for the LDPC coding in the encoding unit 21, for example, a parity matrix $H_T$ similar to the parity check matrix H of the LDPC code defined in the standard such as DVB-T.2 can be adopted.

The parity matrix $H_T$ of the parity check matrix H of the LDPC code defined in the standard such as DVB-T.2 is, as illustrated in Fig. 5, a lower bidiagonal matrix having a staircase structure in which elements of 1 are arranged in a so-called step shape. The row weight of the parity matrix $H_T$ is 1 for the first row and 2 for all the remaining rows. Furthermore, the column weight is 1 for the last one column and 2 for all the remaining columns.

As described above, the LDPC code of the parity check matrix H in which the parity matrix $H_T$ has the staircase structure can be easily generated using the parity check matrix H.

That is, the LDPC code (one code word) is represented by a row vector c, and a column vector obtained by transposing the row vector is represented by $c^T$. Furthermore, a portion of information bits in the row vector c which is an LDPC code is represented by a row vector A, and a portion of parity bits is represented by a row vector T.

In this case, the row vector c can be expressed by an equation $c = [A|T]$ (a row vector in which an element of the row vector A is a left element and an element of the row vector T is a right element) by the row vector A as the information bits and the row vector T as the parity bits.

The parity check matrix H and the row vector $c = [A|T]$ as the LDPC code need to satisfy the equation $Hc^T = 0$, and in a case where the parity matrix $H_T$ of the parity check matrix $H = [H_A|H_T]$ has the staircase structure illustrated in Fig. 5, the row vector T as the parity bits constituting the row vector $c = [A|T]$ satisfying the equation $Hc^T = 0$ can be sequentially calculated by setting the elements of each row to 0 in order from the element of the first row of the column vector $Hc^T$ in the equation $Hc^T = 0$.

Fig. 6 is a diagram for explaining a parity check matrix H of an LDPC code defined in a standard such as DVB-T.2.
For the KX columns from the first column of the parity check matrix H of the LDPC code defined in the standard such as DVB-T.2, the column weight is X, for the subsequent K3 columns, the column weight is 3, for the subsequent M - 1 columns, the column weight is 2, and for the last one column, the column weight is 1.
Here, KX + K3 + M - 1 + 1 is equal to the code length N.

<Processing of Transmission Device 11>

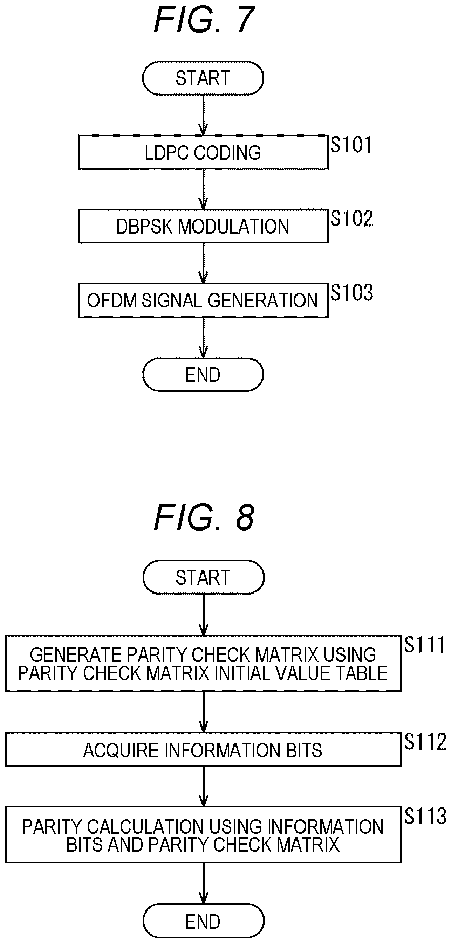

Fig. 7 is a flowchart for explaining an example of processing of the transmission device 11 in Fig. 2.
L0 data and L1 data constituting the LL data are supplied to the encoding unit 21.
In step S101, in the encoding unit 21, the L0 encoding unit 31 sets the L0 data as LDPC target data and performs LDPC coding according to a predetermined parity check matrix for the LDPC target data. The L0 encoding unit 31 supplies the LDPC code of the L0 data obtained as a result of the LDPC coding to the DBPSK modulation unit 22.
Furthermore, in step S101, in the encoding unit 21, the L1 encoding unit 32 sets the L1 data as LDPC target data and performs LDPC coding according to a predetermined parity check matrix for the LDPC target data. The L1 encoding unit 32 supplies the LDPC code of the L1 data obtained as a result of the LDPC coding to the DBPSK modulation unit 22.
Thereafter, the processing proceeds from step S101 to step S102, and the DBPSK modulation unit 22 performs DBPSK modulation of each of the LDPC codes of the L0 data and the L1 data from the L0 encoding unit 31 and the L1 encoding unit 32. The DBPSK modulation unit 22 supplies the L0 carrier and the L1 carrier obtained by the DBPSK modulation to the OFDM signal generation unit 23, and the processing proceeds from step S102 to step S103.
In step S103, the OFDM signal generation unit 23 generates and transmits an OFDM signal including the L0 carrier and the L1 carrier from the DBPSK modulation unit 22, and the TMCC carrier, the pilot carrier, the main data carrier, and the like supplied from a circuit (not illustrated).
Fig. 8 is a flowchart for explaining an example of processing of the encoding unit 21 in Fig. 2.
Fig. 8 illustrates an example of the LDPC coding process performed by the L0 encoding unit 31 and the L1 encoding unit 32 constituting the encoding unit 21 in step S101 of Fig. 7.
In step Sill, the L0 encoding unit 31 and the L1 encoding unit 32 generate the parity check matrix H using the parity check matrix initial value table to be described later, and the processing proceeds to step S112.
In step S112, the L0 encoding unit 31 and the L1 encoding unit 32 acquire a bit string having an information length K (= N $\times$ r) corresponding to the code length N and the coding rate r of the LDPC code corresponding to the parity check matrix H from the LDPC target data as information bits, and the processing proceeds to step S113.
In step S113, the L0 encoding unit 31 and the L1 encoding unit 32 sequentially calculate the parity bits of the code word c satisfying the equation (1) using the information bits of the information length K and the parity check matrix H.

$$Hc^T = 0 \quad \dots (1)$$

In the equation (1), c represents a row vector as a code word (LDPC code), and $c^T$ represents transposition of the row vector c.
Here, as described above, in a case where a portion of the information bits in the row vector c as the LDPC code (one code word) is represented by the row vector A and a portion of the parity bits is represented by the row vector T, the row vector c can be represented by the equation c = [A|T] by the row vector A as the information bits and the row vector T as the parity bits.
The parity check matrix H and the row vector c = [A|T] as the LDPC code need to satisfy the equation $Hc^T = 0$, and in a case where the parity matrix $H_T$ of the parity check matrix H = $[H_A|H_T]$ has the staircase structure illustrated in Fig. 5, the row vector T as the parity bits constituting the row vector c = [A|T] satisfying the equation $Hc^T = 0$ can be sequentially calculated by setting the elements of each row to 0 in order from the element of the first row of the column vector $Hc^T$ in the equation $Hc^T = 0$.
The L0 encoding unit 31 and the L1 encoding unit 32 calculate parity bits T for the information bits A, and output a code word c = [A|T] represented by the information bits A and the parity bits T as an LDPC code of the information bits A.
The L0 encoding unit 31 and the L1 encoding unit 32 repeat acquiring bits of the information length K as information bits in time series from the LDPC target data and calculating parity bits of the information bits until there are no more bits to be acquired as information bits from the LDPC target data.
In the L0 encoding unit 31 and the L1 encoding unit 32, a parity check matrix initial value table (representing a parity check matrix) of LDPC codes with various code lengths N and coding rates r can be prepared in advance. In the L0 encoding unit 31 and the L1 encoding unit 32, the parity check matrix H is generated from the parity check matrix initial value table according to the designation from the outside such as the operator among the parity check matrix initial value tables prepared in advance, and the LDPC coding can be performed using the parity check matrix H.

Note that the L0 encoding unit 31 and the L1 encoding unit 32 can perform parity interleaving to interleave the parity bits of the LDPC code obtained by the LDPC coding to the positions of the other parity bits.

The information matrix $H_A$ of the parity check matrix H corresponding to the LDPC code obtained by performing the LDPC coding by the L0 encoding unit 31 and the L1 encoding unit 32 has a cyclic structure, similarly to the information matrix of the parity check matrix H corresponding to the LDPC code defined in the standard such as DVB-T.2.

The cyclic structure refers to a structure in which a certain column coincides with that obtained by cyclically shifting another column, and includes, for example, a structure in which, for each P columns, the position of 1 in each row of the P columns is cyclically shifted in the column direction by a predetermined value such as a value proportional to a value q obtained by dividing the first column of the P columns by the parity length M. Hereinafter, the P columns in the cyclic structure are appropriately referred to as parallel factors.

In the LDPC code defined in the DVB-T.2 standard, the parallel factor P is defined as 360, which is one of the divisors of the parity length M except 1 and M.

Furthermore, the parity length M is a value other than the prime number represented by an equation $M = q \times P = q \times 360$ using a value q that differs depending on the coding rate. Therefore, similarly to the parallel factor P, the value q is another one of the divisors of the parity length M except 1 and M, and is obtained by dividing the parity length M by the parallel factor P (the product of P and q, which are divisors of the parity length M, becomes the parity length M).

When an integer of 0 or more and less than P is x and an integer of 0 or more and less than q is y, in the parity interleaving, the (K + qx + y + 1)th sign bit among the sign bits of the N-bit LDPC code is interleaved at the position of the (K + Py + x + 1)th sign bit.

Since both the (K + qx + y + 1)th sign bit and the (K + Py + x + 1)th sign bit are the (K + 1)th and subsequent sign bits, they are parity bits. Therefore, according to the parity interleaving, the positions of the parity bits of the LDPC code are moved.

Here, decoding of the LDPC code can be performed by an algorithm called probabilistic decoding proposed by Gallager, that is, a sum product algorithm which is a message passing algorithm by belief propagation on a so-called Tanner graph including a variable node (also referred to as a message node) and a check node. Hereinafter, the variable node and the check node are also simply referred to as nodes as appropriate.

In the sum product algorithm, a variable node operation as a predetermined operation is performed in the variable node by using, as an initial value, a received log likelihood ratio (LLR) of each bit of the LDPC code received on the reception side, that is, a real value representing "0" likelihood of a value of each bit in a log likelihood ratio.

The variable node outputs a result of the variable node operation as a message v.

The check node performs a check node operation as a predetermined operation using the message v output from the variable node, and outputs a result of the check node operation as a message u.

The variable node performs a variable node operation using the message u output from the check node, and outputs a result of the variable node operation as the message u.

The variable node and the check node are connected by an edge corresponding to the parity check matrix.

The variable node corresponds to each column of the parity check matrix, and the check node corresponds to each row of the parity check matrix. In the parity check matrix, the variable node corresponding to the column of the element that is 1 and the check node corresponding to the row of the element are connected by the edge.

The messages v and u are performed between the variable node and the check node connected by the edge.

After the set of the variable node operation and the check node operation is repeated a predetermined number of times of iterative decoding, in the variable node, a predetermined operation similar to the variable node operation is performed using the message u output last by the check node, and a decoding result of the LDPC code is obtained.

According to the parity interleaving described above, (the parity bits corresponding to) the variable nodes connected to the same check node are separated by the parallel factor P. Therefore, in a case where the burst length is less than the parallel factor P, it is possible to avoid a situation in which a plurality of variable nodes connected to the same check node simultaneously becomes errors, and it is possible to improve the resistance to burst errors.

Note that the LDPC code after parity interleaving for interleaving the (K + qx + y + 1)th sign bit to the position of the (K + Py + x + 1)th sign bit matches the LDPC code of the parity check matrix (hereinafter, also referred to as a transformed parity check matrix) obtained by performing column permutation for permutating the (K + qx + y + 1)th column to the (K + Py + x + 1)th column in the original parity check matrix H.

Furthermore, in the parity matrix of the transformed parity check matrix, a pseudo cyclic structure in units of P columns appears.

Here, the pseudo cyclic structure means a structure in which a part except for a part is a cyclic structure.

The transformed parity check matrix obtained by applying column permutation corresponding to parity interleaving to the parity check matrix of the LDPC code defined in the standard such as DVB-T.2 does not have only one element of 1 (it is an element of 0) in the portion of P rows $\times$ P columns = 360 rows $\times$ 360 columns (shift matrix as described later) in the upper right corner portion of the transformed parity check matrix, and in that respect, the transformed parity check matrix has a pseudo cyclic structure instead of a (complete) cyclic structure.

As the parity check matrix used in the L0 encoding unit 31 and the L1 encoding unit 32, a matrix in which the transformed parity check matrix has a pseudo cyclic structure can be adopted, for example, similarly to the transformed parity check matrix for the parity check matrix of the LDPC code defined in the standard such as DVB-T.2.

Note that the transformed parity check matrix is a matrix obtained by applying, to the original parity check matrix H, row permutation for causing the transformed parity check matrix to be configured by a configuration matrix to be described later, in addition to column permutation corresponding to parity interleaving.

<Parity Check Matrix Initial Value Table>

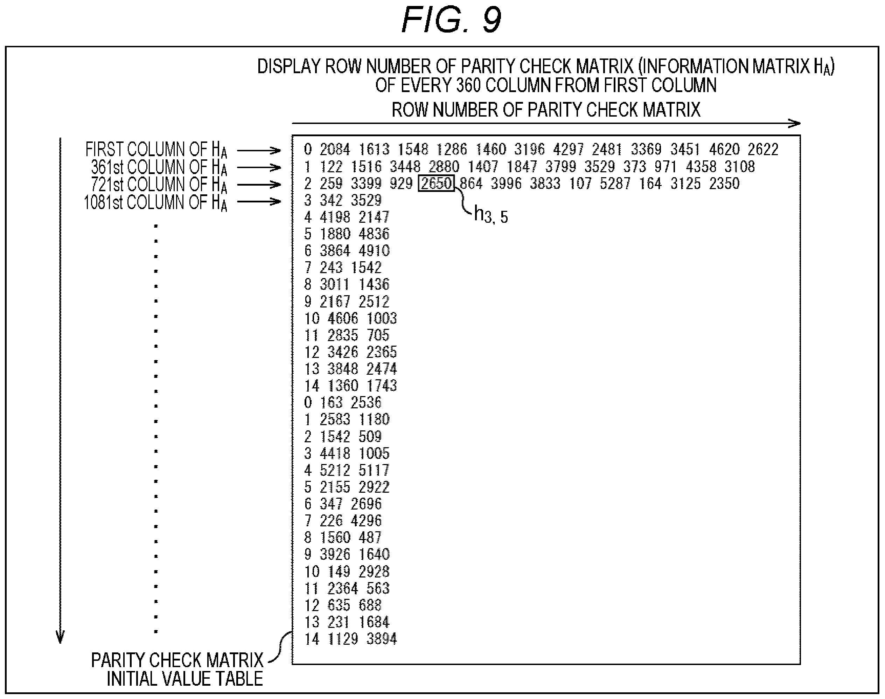

Fig. 9 is a diagram for explaining a method of obtaining the parity check matrix H from the parity check matrix initial value table by the type B method.

The parity check matrix initial value table is, for example, a table representing the positions of the elements of 1 of the information matrix $H_A$ (Fig. 4) corresponding to the information length K according to the code length N and the coding rate r of the LDPC code (the LDPC code defined by the parity check matrix H) in the parity check matrix H for each P columns which is a parallel factor, and is created in advance for each parity check matrix H.

The parity check matrix initial value table represents at least the positions of the elements of 1 of the information matrix $H_A$ for every P columns.

In addition, the parity check matrix H includes a parity check matrix in which all of the parity matrix $H_T$ has a staircase structure, and a parity check matrix in which a part of the parity matrix $H_T$ has a staircase structure and the other part is a diagonal matrix (identity matrix).

Hereinafter, an expression method of the parity check matrix initial value table representing the parity check matrix in which a part of the parity matrix $H_T$ has a staircase structure and the other part is a diagonal matrix is also referred to as a type A method. Furthermore, an expression method of the parity check matrix initial value table representing the parity check matrix in which all the parity matrices $H_T$ have the staircase structure is also referred to as a type B method.

Furthermore, the LDPC code for the parity check matrix represented by the parity check matrix initial value table by the type A method is also referred to as a type A code, and the LDPC code for the parity check matrix represented by the parity check matrix initial value table by the type B method is also referred to as a type B code.

The designations "type A" and "type B" are designations according to the standard of ATSC 3.0. For example, in ATSC 3.0, both the type A code and the type B code are adopted. In DVB-T.2 and the like, a type B code is adopted.

Fig. 9 illustrates a parity check matrix initial value table of a type B code with a code length N of 16200 bits and a coding rate r of 2/3, which is defined in the DVB-T.2 standard.

In a case where the type B code is adopted in the encoding unit 21 ((both or one of the L0 encoding unit 31 and the L1 encoding unit 32 in Fig. 2), the encoding unit 21 obtains the parity check matrix H as follows using the parity check matrix initial value table by the type B method.

The parity check matrix initial value table by the type B method is a table representing the positions of the elements of 1 of the entire information matrix $H_A$ corresponding to the information length K according to the code length N and the coding rate r of the LDPC code for each P columns.

The parallel factor P of the type B code defined in the DVB-T.2 standard is 360, and in the i-th row of the parity check matrix initial value table, the row numbers of the elements of 1 of the $(1 + 360 \times (i - 1))$th column of the parity check matrix H (the row numbers in which the row number of the first row of the parity check matrix H is 0) are arranged by the number of the column weights of the $(1 + 360 \times (i - 1))$th column.

Here, since the parity matrix $H_T$ (Fig. 4) corresponding to the parity length M of the parity check matrix H by the type B method has a staircase structure as illustrated in Fig. 5, if the information matrix $H_A$ (Fig. 4) corresponding to the information length K can be obtained from the parity check matrix initial value table, the parity check matrix H can be obtained.

The number of rows k + 1 of the parity check matrix initial value table by the type B method varies depending on the information length K.

The relationship of the equation (2) holds between the information length K and the number of rows k + 1 of the parity check matrix initial value table.

$$K = (k + 1) \times P \quad \ldots (2)$$

Here, the parallel factor P of the equation (2) is 360 for the type B code defined in the DVB-T.2 standard as described above.

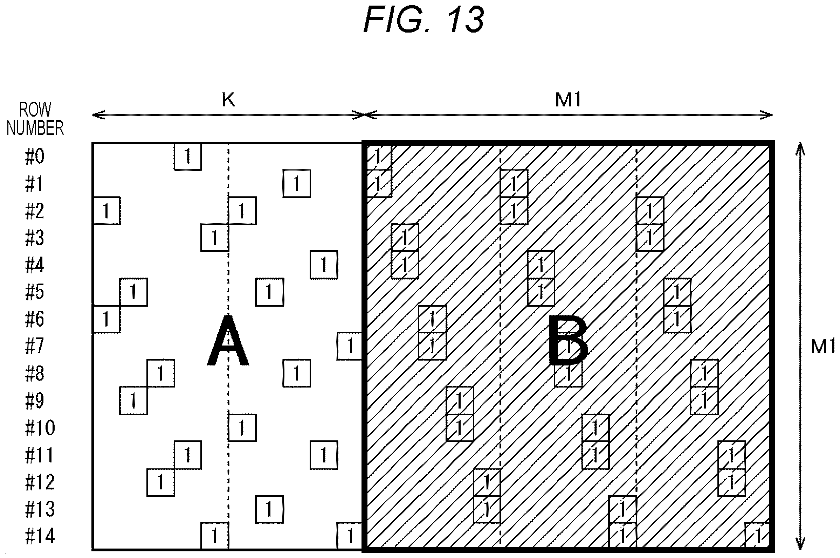

In the parity check matrix initial value table in Fig. 9, 13 numerical values are arranged in the first to third rows, and three numerical values are arranged in the fourth to (k + 1)th rows (in Fig. 9, line 30).

Therefore, the column weight of the parity check matrix H obtained from the parity check matrix initial value table in Fig. 9 is 13 from the first to (1 + 360 × (3 - 1) - 1)th columns, and is 3 from the (1 + 360 × (3 - 1))th to K-th columns.

The first row of the parity check matrix initial value table in Fig. 9 is 0, 2084, 1613, 1548, 1286, 1460, 3196, 4297, 2481, 3369, 3451, 4620, and 2622, which indicates that, in the first column of the parity check matrix H, the elements of the rows with the row numbers of 0, 2084, 1613, 1548, 1286, 1460, 3196, 4297, 2481, 3369, 3451, 4620, and 2622 are 1 (and other elements are 0) .

Furthermore, the second row of the parity check matrix initial value table in Fig. 9 is 1, 122, 1516, 3448, 2880, 1407, 1847, 3799, 3529, 373, 971, 4358, and 3108, which indicates that, in the 361 (= 1 + 360 × (2 - 1))th column of the parity check matrix H, the elements of the rows with the row numbers of 1, 122, 1516, 3448, 2880, 1407, 1847, 3799, 3529, 373, 971, 4358, and 3108 are 1.

As described above, the parity check matrix initial value table represents the positions of the elements of 1 of the information matrix $H_A$ of the parity check matrix H in every 360 columns.

The columns other than the (1 + 360 × (i - 1))th column of the parity check matrix H, that is, the (2 + 360 × (i - 1))th to (360 × i)th columns are obtained by cyclically shifting and arranging the elements of 1 of the (1 + 360 × (i - 1))th column determined by the parity check matrix initial value table downward (downward of the columns) according to the parity length M.

That is, for example, the (2 + 360 × (i - 1))th column is obtained by cyclically shifting the (1 + 360 × (i - 1))th column downward by M/P = M/360 (= q), and the next (3 + 360 × (i - 1))th column is obtained by cyclically shifting the (1 + 360 × (i - 1))th column downward by 2 × M/360 (= 2 × q) (cyclically shifting the (2 + 360 × (i - 1))th column downward by M/360 (= q)).

Now, when the numerical value of the j-th column (j-th from the left) in the i-th row (i-th from the top) of the parity check matrix initial value table is represented as $h_{i,j}$, and the row number of the element of j-th 1 in the w-th column of the parity check matrix H is represented as $H_{w-j}$, the row number $H_{w-j}$ of the element of 1 in the w-th column that is a column other than the (1 + 360 × (i - 1))th column of the parity check matrix H can be obtained by the equation (3).

$$H_{w-j} = \mathrm{mod}(h_{i,j} + \mathrm{mod}((w - 1), P) \times q, M) \quad \ldots (3)$$

Here, mod (x, y) means a remainder when x is divided by y. q is a value M/360 obtained by dividing the parity length M by the parallel factor P (= 360).

In the generation of the parity check matrix using the parity check matrix initial value table in Fig. 9, the row number of the element of 1 in the (1 + 360 × (i - 1))th column of the parity check matrix H is specified by the parity check matrix initial value table. Furthermore, the row number $H_{w-j}$ of the element of 1 in the w-th column that is a column other than the (1 + 360 × (i - 1))th column of the parity check matrix H is specified according to the equation (3).

Then, the parity check matrix H in which the element of the row number specified as described above is 1 is generated.

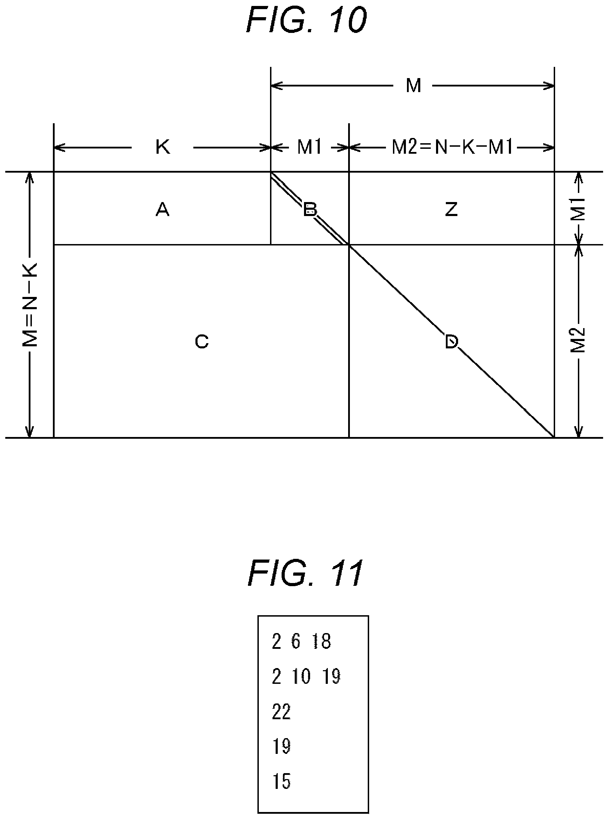

Fig. 10 is a diagram illustrating a structure of the parity check matrix H by the type A method.

The parity check matrix by the type A method includes an A matrix, a B matrix, a C matrix, a D matrix, and a Z matrix.

The A matrix is an upper left matrix of the parity check matrix H in M1 rows and K columns represented by a predetermined value M1 and an information length K = code length N × coding rate r of the LDPC code.

The B matrix is a matrix of M1 rows and M1 columns and having a staircase structure adjacent to the right of the A matrix.

The C matrix is a matrix adjacent below the A matrix and the B matrix in N - K - M1 rows and K + M1 columns.

The D matrix is an identity matrix of N - K - M1 rows and N - K - M1 columns adjacent to the right of the C matrix.

The Z matrix is a zero matrix (0 matrix) of M1 rows and N - K - M1 columns adjacent to the right of the B matrix.

When M2 = N - K - M1, the C matrix can be expressed as a matrix of M2 rows and K + M1 columns, the D matrix can be expressed as an identity matrix of M2 rows and M2 columns, and the Z matrix can be expressed as a zero matrix of M1 rows and M2 columns.

In the parity check matrix H by the type A method including the A matrix to the D matrix and the Z matrix as described above, a part of the A matrix and the C matrix constitute an information matrix, and the B matrix, the remaining portion of the C matrix, the D matrix, and the Z matrix constitute a parity matrix.

Note that, since the B matrix is a matrix having a staircase structure and the D matrix is an identity matrix, a part (portion of the B matrix) of the parity matrix of the parity check matrix H by the type A method has a staircase structure, and the other part (portion of the D matrix) is a diagonal matrix (identity matrix).

Similarly to the information matrix of the parity check matrix H by the type B method, the A matrix and the C matrix have a cyclic structure for each P columns which is a parallel factor, and the parity check matrix initial value table by the type A method represents the positions of the elements of 1 of the A matrix and the C matrix for each P columns. For example, the parallel factor of the type A code defined in the standard of ATSC 3.0 is 360.

Here, since the parity check matrix initial value table by the type A method represents the positions of the elements of 1 of the A matrix and the C matrix of the parity check matrix for every P columns, it can be said that the positions of the elements of 1 of a part of the parity check matrix are represented for every P columns.

Furthermore, since a part of the A matrix and the C matrix constitute an information matrix, it can be said that the parity check matrix initial value table by the type A method representing the positions of the elements of 1 of the A matrix and the C matrix for every P columns represents at least the positions of the elements of 1 of the information matrix for every P columns.

Fig. 11 is a diagram illustrating an example of a parity check matrix initial value table by the type A method.

In other words, Fig. 11 illustrates an example of a parity check matrix initial value table representing the parity check matrix H having the code length N of 35 bits and the coding rate r of 2/7.

The parity check matrix initial value table by the type A method is a table representing the positions of the elements of 1 of the A matrix and the C matrix for each parallel factor P. In the i-th row, row numbers of the elements of 1 of the (1 + P × (i - 1))th column of the parity check matrix H (row numbers in which the row number of the first row of the parity check matrix H is 0) are arranged by the number of column weights of the (1 + P × (i - 1))th column.

Note that, here, the parallel factor P is, for example, 5.

The parity check matrix H by the type A method includes M1, M2, Q1, and Q2 as parameters other than the parallel factor P and the like.

M1 (Fig. 10) is a parameter for determining the size of the B matrix, and has a value that is a multiple of the parallel factor P. By adjusting M1, the performance of the LDPC code changes, and is adjusted to a predetermined value when the parity check matrix H is determined. Here, 15, which is three times the parallel factor P = 5, is employed as M1.

M2 (Fig. 10) takes a value M - M1 obtained by subtracting M1 from the parity length M.

Here, since the information length K is N × r = 35 × 2/7 = 10, the parity length M is N - K = 35 - 10 = 25. Therefore, M2 is M - M1 = 25 - 15 = 10.

Q1 is obtained according to an equation Q1 = M1/P, and represents the number of cyclic shifts (the number of rows) in the A matrix.

That is, the columns other than the (1 + P × (i - 1))th column of the A matrix of the parity check matrix H by the type A method, that is, the (2 + P × (i - 1))th to (P × i)th columns are arranged by cyclically shifting the elements of 1 of the (1 + P × (i - 1))th column determined by the parity check matrix initial value table downward (downward of the columns), and Q1 represents the number of shifts of the cyclic shift in the A matrix.

Q2 is obtained according to an equation Q2 = M2/P, and represents the number of shifts (the number of rows) of cyclic shift in the C matrix.

That is, the columns other than the (1 + P × (i - 1))th column of the C matrix of the parity check matrix H by the type A method, that is, the (2 + P × (i - 1))th to (P × i)th columns are arranged by cyclically shifting the elements of 1 of the (1 + P × (i - 1))th column determined by the parity check matrix initial value table downward, and Q2 represents the number of shifts of the cyclic shift in the C matrix.

Here, Q1 is M1/P = 15/5 = 3, and Q2 is M2/P = 10/5 = 2.

In the parity check matrix initial value table in Fig. 11, three numerical values are arranged in the first and second rows, and one numerical value is arranged in the third to fifth rows. According to the arrangement of the numerical values, the column weights of the A matrix and the C matrix of the parity check matrix H obtained from the parity check matrix initial value table in Fig. 11 are 3 from the (1 = 1 + 5 × (1 - 1))th column to the (10 = 5 × 2)th column, and are 1 from the (11 = 1 + 5 × (3 - 1))th column to the (25 = 5 × 5)th column.

The first row of the parity check matrix initial value table in Fig. 11 is 2, 6, and 18, which indicates that, in the first column of the parity check matrix H, the elements of the rows with the row numbers 2, 6, and 18 are 1 (and other elements are 0).

Here, in this case, since the A matrix (Fig. 10) is a matrix of 15 rows and 10 columns (M1 rows and K columns) and the C matrix (Fig. 10) is a matrix of 10 rows and 25 columns (N - K - M1 rows and K + M1 columns), the rows with the row numbers 0 to 14 of the parity check matrix H are rows of the A matrix, and the rows with the row numbers 15 to 24 of the parity check matrix H are rows of the C matrix.

Therefore, among the rows with the row numbers 2, 6, and 18 (hereinafter, it is described as row #2, #6, and #18), the rows #2 and #6 are rows of the A matrix, and the row #18 is a row of the C matrix.

The second row of the parity check matrix initial value table in Fig. 11 is 2, 10, and 19, which indicates that, in the 6 (= 1 + 5 × (2 - 1))th column of the parity check matrix H, the elements of the rows #2, #10, and #19 are 1.

Here, in the 6 (= 1 + 5 × (2 - 1))th column of the parity check matrix H, among the rows #2, #10, and #19, the rows #2 and #10 are rows of the A matrix, and the row #19 is a row of the C matrix.

The third row of the parity check matrix initial value table in Fig. 11 is 22, which indicates that, in the 11 (= 1 + 5 × (3 - 1))th column of the parity check matrix H, the element of the row #22 is 1.

Here, in the 11 (= 1 + 5 × (3 - 1))th column of the parity check matrix H, the row #22 is a row of the C matrix.

Similarly, 19 in the fourth row of the parity check matrix initial value table in Fig. 11 indicates that the element of the row #19 is 1 in the 16 (= 1 + 5 × (4 - 1))th column of the parity check matrix H, and 15 in the fifth row of the parity check matrix initial value table in Fig. 11 indicates that the element of the row #15 is 1 in the 21 (= 1 + 5 × (5 - 1))th column of the parity check matrix H.

As described above, the parity check matrix initial value table represents the positions of the elements of 1 of the A matrix and the C matrix of the parity check matrix H for every parallel factor P = 5 columns.

The columns other than the (1 + 5 × (i - 1))th column of the A matrix and the C matrix of the parity check matrix H, that is, the (2 + 5 × (i - 1))th to (5 × i)th columns are arranged by cyclically shifting the elements of 1 of the (1 + 5 × (i - 1))th column determined by the parity check matrix initial value table downward (downward of the columns) according to the parameters Q1 and Q2.

That is, for example, the (2 + 5 × (i - 1))th column of the A matrix is obtained by cyclically shifting the (1 + 5 × (i - 1))th column downward by Q1 (= 3), and the next (3 + 5 × (i - 1))th column is obtained by cyclically shifting the (1 + 5 × (i - 1))th column downward by 2 × Q1 (= 2 × 3) ((2 + 5 × (i - 1))th column cyclically shifted downward by Q1).

Furthermore, for example, the (2 + 5 × (i - 1))th column of the C matrix is obtained by cyclically shifting the (1 + 5 × (i - 1))th column downward by Q2 (= 2), and the next (3 + 5 × (i - 1))th column is obtained by cyclically shifting the (1 + 5 × (i - 1))th column downward by 2 × Q2 (= 2 × 2) ((2 + 5 × (i - 1))th column cyclically shifted downward by Q2).

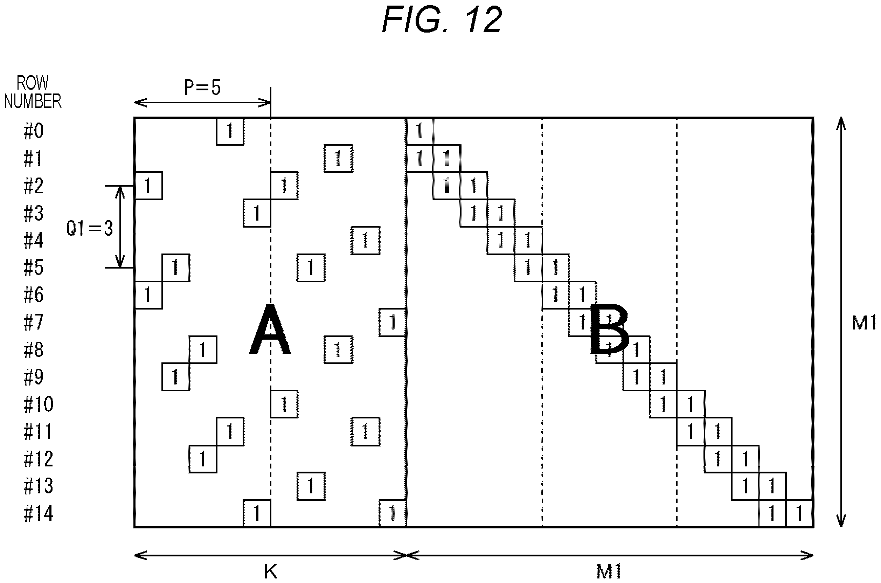

Fig. 12 is a diagram illustrating an A matrix generated from the parity check matrix initial value table in Fig. 11.

In the A matrix in Fig. 12, the elements of the rows #2 and #6 of the 1 (= 1 + 5 × (1 - 1))th column are 1 according to the first row of the parity check matrix initial value table in Fig. 11.

Then, the 2 (= 2 + 5 × (1 - 1))th to 5 (= 5 + 5 × (1 - 1))th columns are obtained by cyclically shifting the previous columns downward by Q1 = 3.

Furthermore, in the A matrix in Fig. 12, the elements of the rows #2 and #10 of the 6 (= 1 + 5 × (2 - 1))th column are 1 according to the second row of the parity check matrix initial value table in Fig. 11.

Then, the 7 (= 2 + 5 × (2 - 1))th to 10 (= 5 + 5 × (2 - 1))th columns are obtained by cyclically shifting the previous columns downward by Q1 = 3.

Fig. 13 is a diagram illustrating parity interleaving of the B matrix.

In the generation of the parity check matrix using the parity check matrix initial value table of type A, the A matrix is generated using the parity check matrix initial value table, and the B matrix having the staircase structure is arranged on the right of the A matrix. Then, the B matrix is regarded as a parity matrix, and parity interleaving is performed such that adjacent elements of 1 of the B matrix having a staircase structure are separated by a parallel factor P = 5 in the row direction.

Fig. 13 illustrates the A matrix and the B matrix after the parity interleaving of the B matrix in Fig. 12.

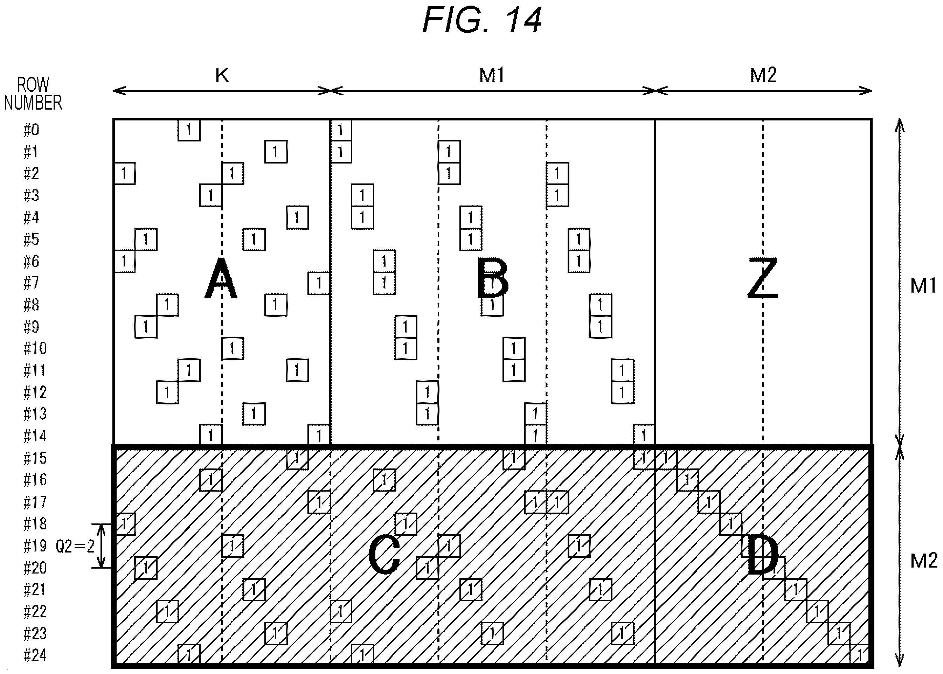

Fig. 14 is a diagram illustrating a C matrix generated from the parity check matrix initial value table in Fig. 11.

In the C matrix in Fig. 14, according to the first row of the parity check matrix initial value table in Fig. 11, the element of the row #18 of the first (= 1 + 5 × (1 - 1)) column of the parity check matrix H is 1.

Then, the 2 (= 2 + 5 × (1 - 1))th to 5 (= 5 + 5 × (1 - 1))th columns of the C matrix are obtained by cyclically shifting the previous columns downward by Q2 = 2.

Furthermore, in the C matrix in Fig. 14, according to the second to fifth rows of the parity check matrix initial value table in Fig. 11, the elements of the row #19 of the 6 (= 1 + 5 × (2 - 1))th column, the row #22 of the 11 (= 1 + 5 × (3 - 1))th column, the row #19 of the 16 (= 1 + 5 × (4 - 1))th column, and the row #15 of the 21 (= 1 + 5 × (5 - 1))th column of the parity check matrix H are 1.

Then, the 7 (= 2 + 5 × (2 - 1))th to 10 (= 5 + 5 × (2 - 1))th columns, the 12 (= 2 + 5 × (3 - 1))th to 15 (= 5 + 5 × (3 - 1))th columns, the 17 (= 2 + 5 × (4 - 1))th to 20 (= 5 + 5 × (4 - 1))th columns, and the 22 (= 2 + 5 × (5 - 1))th to 25 (= 5 + 5 × (5 - 1))th columns are obtained by cyclically shifting the previous columns downward by Q2 = 2.

In the generation of the parity check matrix using the parity check matrix initial value table of type A, a C matrix is generated using the parity check matrix initial value table, and the C matrix is arranged below the A matrix and the B matrix (after parity interleaving).

Furthermore, the Z matrix is arranged adjacent to the right of the B matrix, and the D matrix is arranged adjacent to the right of the C matrix, and the parity check matrix illustrated in Fig. 14 is generated.

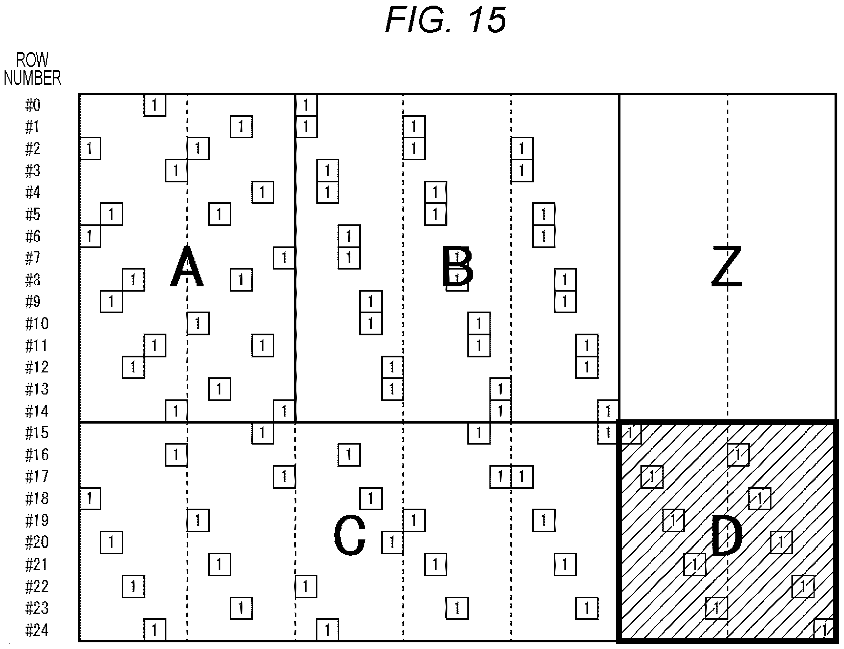

Fig. 15 is a diagram illustrating parity interleaving of the D matrix.

In the generation of the parity check matrix using the parity check matrix initial value table of type A, after the parity check matrix of Fig. 14 is generated, the D matrix is regarded as a parity matrix, and parity interleaving (of only the D matrix) is performed such that the elements of 1 of the odd rows and the next even rows of the D matrix as the identity matrix are separated in the row direction by the parallel factor P = 5.

Fig. 15 illustrates a parity check matrix H obtained by performing parity interleaving on the D matrix for the parity check matrix illustrated in Fig. 14.

The LDPC code generated using the parity check matrix H in Fig. 15 is an LDPC code subjected to parity interleaving. Therefore, for the LDPC code generated using the parity check matrix H in Fig. 15, it is not necessary to separately perform parity interleaving after the generation of the LDPC code.

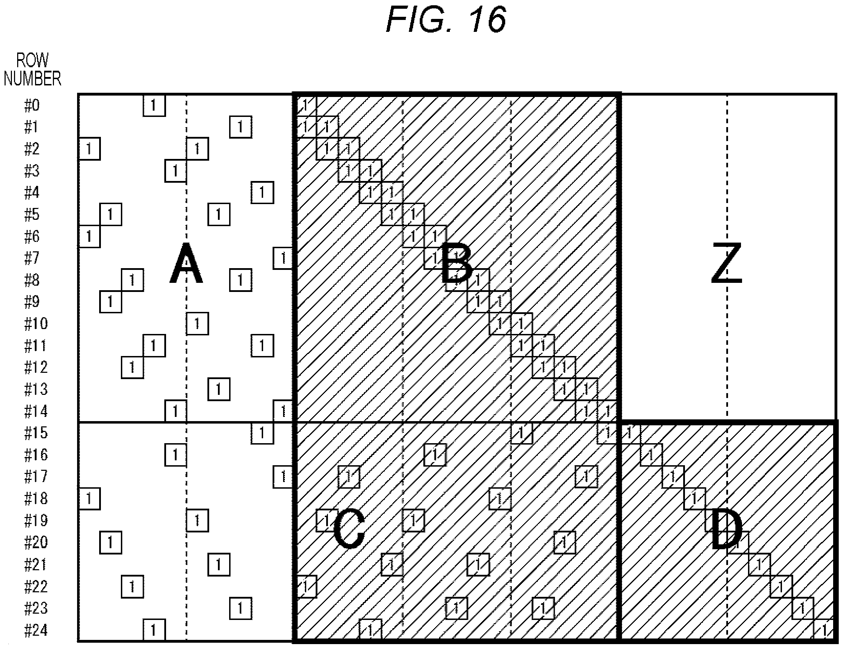

Fig. 16 is a diagram illustrating a parity check matrix in which column permutation as parity deinterleaving for restoring the parity interleaving is performed for the B matrix, a part of the C matrix (portion of C matrix arranged below B matrix), and the D matrix of the parity check matrix H in Fig. 15.

The LDPC coding can be performed using the parity check matrix in Fig. 16 instead of the parity check matrix H in Fig. 15.

In a case where the LDPC coding is performed using the parity check matrix H in Fig. 16, an LDPC code on which parity interleaving is not performed is obtained. Therefore, in a case where parity interleaving is necessary, when LDPC coding is performed using the parity check matrix in Fig. 16, it is necessary to perform parity interleaving for the LDPC code after the LDPC code is generated by the LDPC coding.

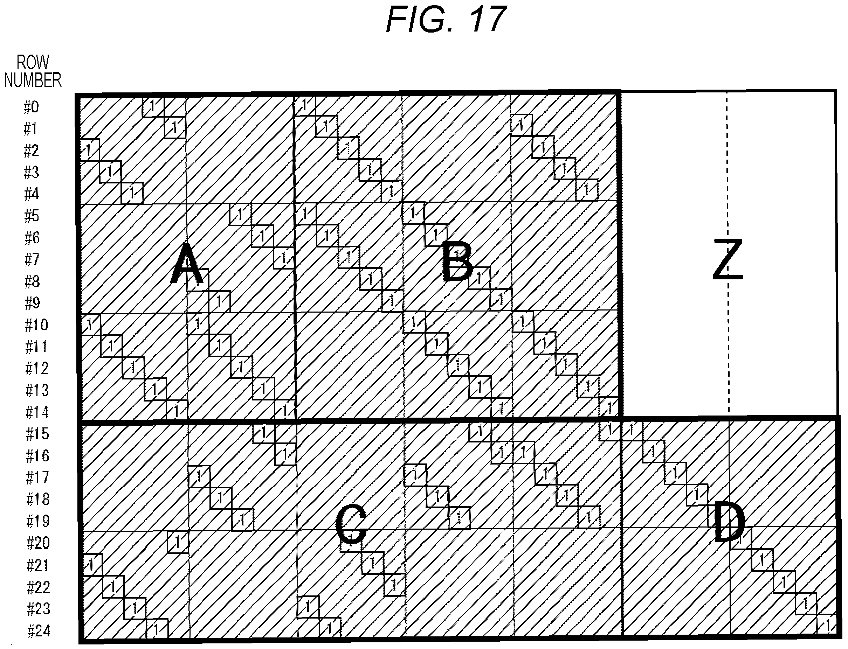

Fig. 17 is a diagram illustrating a transformed parity check matrix obtained by performing row permutation for the parity check matrix H in Fig. 15.

As described later, the transformed parity check matrix is a matrix represented by a combination of a P × P identity matrix, a quasi identity matrix in which one or more of 1s in the identity matrix are 0, a shift matrix obtained by cyclically shifting the identity matrix or the quasi identity matrix, a sum matrix that is a sum of two or more of the identity matrix, the quasi identity matrix, or the shift matrix, and a P × P zero matrix.

By using the transformed parity check matrix for decoding the LDPC code, it is possible to adopt an architecture in which P check node operations and variable node operations are simultaneously performed in decoding the LDPC code as described later.

<New LDPC Code>

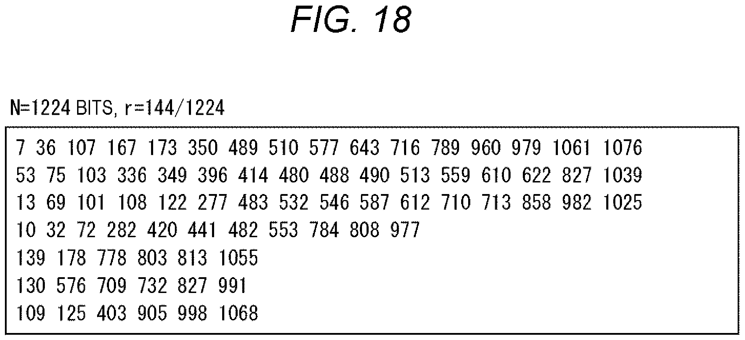

Fig. 18 is a diagram illustrating a first example of a parity check matrix initial value table representing a parity check matrix of a new LDPC code.

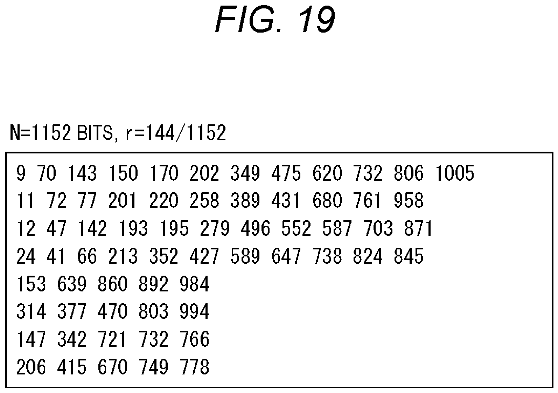

Fig. 19 is a diagram illustrating a second example of a parity check matrix initial value table representing a parity check matrix of a new LDPC code.

In data transmission using an LDPC code, there is a method of using an LDPC code with good performance as one of methods of securing good communication quality.

Hereinafter, a new high-performance LDPC code (hereinafter, also referred to as a new LDPC code) will be described.

Here, for example, a new LDPC code that can be adopted as the LDPC code of the L0 data with high urgency will be described.

As the new LDPC code, either a type A code or a type B code corresponding to the parity check matrix H having a cyclic structure can be adopted. The parity check matrix initial value table in Figs. 18 and 19 is a parity check matrix initial value table of a type A code (parity check matrix initial value table by the type A method).

The LDPC code of the L0 data is subjected to DBPSK modulation and becomes an L0 carrier. Therefore, a 1-bit LDPC code is transmitted by one L0 carrier.

In addition, as described with reference to Fig. 3, eight L0 carriers are arranged in each of the nine partial receivable OFDM segments in the center, so that 72 (= 9 * 8) L0 carriers are arranged in one OFDM symbol.

Therefore, a multiple of 72 is adopted as the code length N of the LDPC code of the L0 data.

When the code length of the LDPC code is 1000 bits or more, the performance is improved as compared with the turbo code, and the performance is improved as the code length is longer. On the other hand, when the code length is long, the time required for decoding the LDPC code becomes longer as the code length is longer according to the code length.

Therefore, the code length N of the LDPC code of the L0 data is preferably long from the viewpoint of performance, but is preferably short from the viewpoint of low latency transmission of the L0 data.

As described above, there is a trade-off relationship between the performance of the LDPC code and the low latency transmission of the L0 data.

Therefore, in order to balance the performance of the LDPC code and the low latency transmission of the L0 data, a multiple of 72 and a value of 1000 bits, for example, 1224 bits or 1152 bits is adopted as the code length N of the new LDPC code as the LDPC code of the L0 data.

In the comparison between the LDPC codes with the code lengths N of 1224 bits and 1152 bits, the LDPC code with the code length N of 1224 bits has better performance than the LDPC code with the code length N of 1152 bits. On the other hand, the LDPC code with the code length N of 1152 bits can perform low latency transmission as compared with the LDPC code with the code length N of 1224 bits.

Note that, the code length N which is a multiple of 72 and has a value of 1000 bits includes, for example, 1008 bits and 1080 bits. However, in the present embodiment, an LDPC code having a code length of 1224 bits or 1152 bits is adopted as the new LDPC code.

Furthermore, since the LDPC code of the L0 data with high urgency is required to be correctly decoded even with a low carrier-to-noise ratio (CNR), an information length K with a coding rate r of about 0.1, for example, 144 bits is adopted.

Fig. 18 illustrates an example of a parity check matrix initial value table representing a parity check matrix of an LDPC code with the code length N of 1224 bits and the information length K of 144 bits and, therefore, a new LDPC code with the coding rate r of 144/1224.

Fig. 19 illustrates an example of a parity check matrix initial value table representing a parity check matrix of an LDPC code with the code length N of 1152 bits and the information length K of 144 bits and, therefore, a new LDPC code with the coding rate r of 144/1152.

Note that the new LDPC code corresponding to the parity check matrix initial value table in Figs. 18 and 19 can be applied to any LDPC coding in addition to the LDPC coding of the L0 data transmitted in the partial reception band.

Since the code length N of the new LDPC code is as short as 1224 or 1152 bits, the new LDPC code is particularly useful for information transmission with a low latency.

The parallel factor P of the new LDPC code is 36. As described above, the parallel factor P of the new LDPC code is 36 which is large for the code length N, and it is possible to use an architecture in which P = 36 check node operations and variable node operations for decoding the LDPC code of the parity check matrix represented by the $P \times P$ configuration matrix described later are simultaneously performed at maximum, and it is possible to perform decoding of the LDPC code at high speed. From such a point as well, the new LDPC code is useful for information transmission with a low latency.

Here, the high-performance LDPC code is an LDPC code obtained from an appropriate parity check matrix H.

The appropriate parity check matrix H is, for example, a parity check matrix that satisfies a predetermined condition that makes a bit error rate (BER) (and a frame error rate (FER)) smaller when an LDPC code obtained from the parity check matrix H is transmitted at a low $E_s/N_0$ (signal power-to-noise power ratio per symbol) or $E_b/N_o$ (signal power-to-noise power ratio per bit) .

The appropriate parity check matrix H can be obtained, for example, by performing simulation for measuring BER when an LDPC code obtained from various parity check matrices satisfying a predetermined condition is transmitted at a low $E_s/N_o$.

Examples of the predetermined condition to be satisfied by the appropriate parity check matrix H include that an analysis result obtained by a code performance analysis method called density evolution is good, that there is no loop of elements of 1 called cycle 4, and the like.

Here, in the information matrix $H_A$, it is known that the decoding performance of the LDPC code deteriorates when the elements of 1 are dense as in cycle 4, and thus, it is desirable that cycle 4 does not exist in the parity check matrix H.

In the parity check matrix H, the minimum value of the length (loop length) of the loop constituted by the elements of 1 is called girth. The absence of cycle 4 means that the girth is greater than 4.

Note that the predetermined condition to be satisfied by the appropriate parity check matrix H can be appropriately determined from the viewpoint of improving the decoding performance of the LDPC code, facilitating (simplifying) the decoding processing of the LDPC code, and the like.

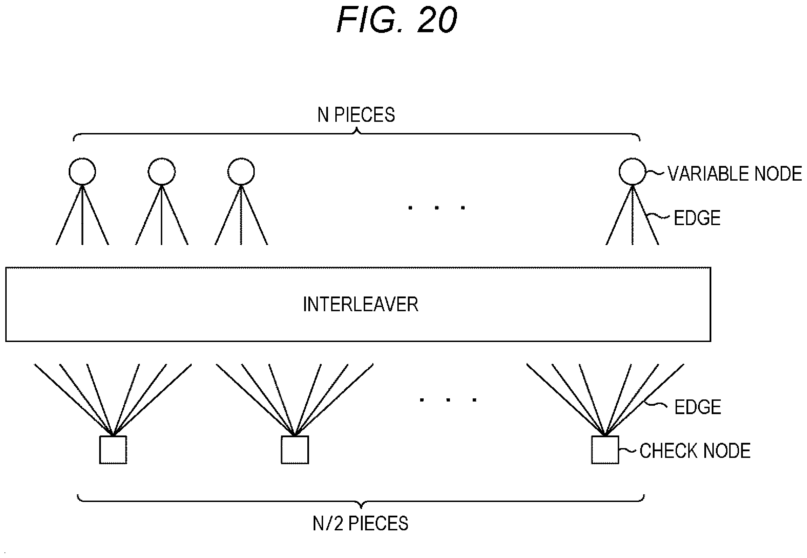

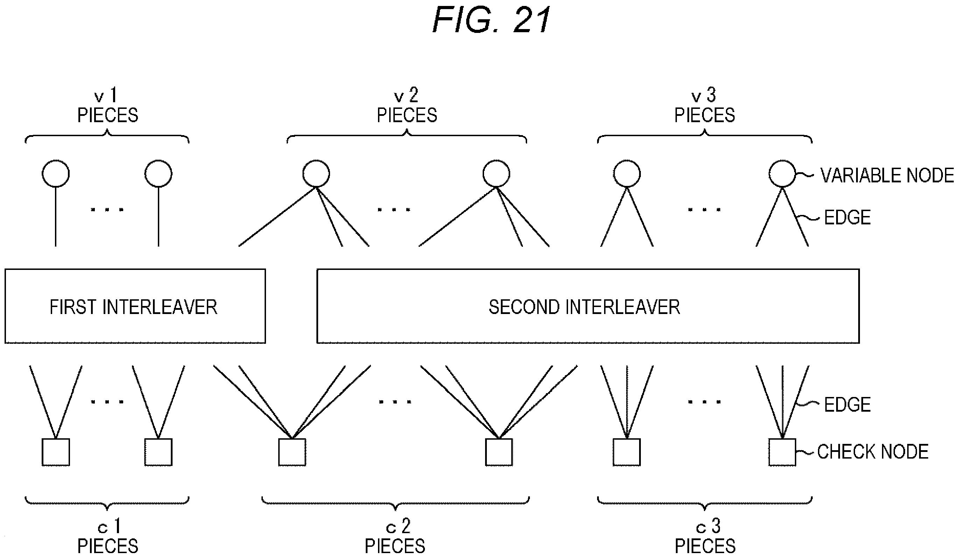

Figs. 20 and 21 are diagrams for explaining density evolution by which an analysis result as a predetermined condition to be satisfied by an appropriate parity check matrix H can be obtained.

The density evolution is a code analysis method for calculating an expected value of an error probability of an entire LDPC code (ensemble) having a code length N of $\infty$ characterized by a degree sequence as described later.

For example, when the noise variance value is gradually increased from 0 on an additive white Gaussian noise (AWGN) channel, the expected value of the error probability of a certain ensemble is initially 0, but is not 0 when the noise variance value becomes a certain threshold or more.

According to the density evolution, it is possible to determine whether the performance of the ensemble (appropriateness of the parity check matrix) is good or bad by comparing the threshold (hereinafter, also referred to as a performance threshold) of the variance value of the noise at which the expected value of the error probability is not 0.

Note that, when an ensemble to which a specific LDPC code belongs is determined and density evolution is performed on the ensemble, rough performance of the LDPC code can be predicted.

Therefore, if a high-performance ensemble is found, the high-performance LDPC code can be found from the LDPC codes belonging to the ensemble.

Here, the degree sequence described above represents a ratio of variable nodes and check nodes having weights of respective values to the code length N of the LDPC code.

For example, a regular (3, 6)LDPC code with a coding rate of 1/2 belongs to an ensemble characterized by a degree sequence in which weights (column weights) of all variable nodes are 3 and weights (row weights) of all check nodes are 6.

Fig. 20 illustrates a Tanner graph of such an ensemble.

In the Tanner graph of Fig. 20, there are N variable nodes indicated by circles (o) in the drawing, the number being equal to the code length N, and there are N/2 check nodes indicated by squares (A) in the drawing, the number being equal to a multiplication value obtained by multiplying the code length N by the coding rate 1/2.

Three edges equal to the column weight are connected to each variable node, and thus, there are 3N edges in total connected to the N variable nodes.

Furthermore, six edges equal to the row weight are connected to each check node, and thus, there are a total of 3N edges connected to N/2 check nodes.

Furthermore, in the Tanner graph of Fig. 20, there is one interleaver.

The interleaver randomly rearranges the 3N edges connected to the N variable nodes, and connects each rearranged edge to any one of the 3N edges connected to the N/2 check nodes.

The rearrangement pattern for rearranging 3N edges connected to N variable nodes in the interleaver is (3N)! (= (3N) × (3N - 1) × ... × 1) Therefore, the ensemble characterized by the degree sequence that the weights of all the variable nodes are 3 and the weights of all the check nodes are 6 is (3N)! a set of LDPC codes.

In a simulation for obtaining a high-performance LDPC code (appropriate parity check matrix), a multi edge type ensemble can be used in density evolution.

In the multi edge type, the interleaver through which the edge connected to the variable node and the edge connected to the check node pass is divided into a plurality of (multi edges), whereby the ensemble is characterized more strictly.

Fig. 21 illustrates an example of a Tanner graph of a multi edge type ensemble.

In the Tanner graph of Fig. 21, there are two interleavers: a first interleaver and a second interleaver.

In addition, in the Tanner graph of Fig. 21, there are v1 variable nodes each having one edge connected to the first interleaver and 0 edges connected to the second interleaver, v2 variable nodes each having one edge connected to the first interleaver and two edges connected to the second interleaver, and v3 variable nodes each having 0 edges connected to the first interleaver and two edges connected to the second interleaver.

Furthermore, in the Tanner graph of Fig. 21, there are c1 check nodes each having two edges connected to the first interleaver and 0 edges connected to the second interleaver, c2 check nodes each having two edges connected to the first interleaver and two edges connected to the second interleaver, and c3 check nodes each having 0 edges connected to the first interleaver and 3 edges connected to the second interleaver.

Here, the density evolution and the implementation thereof are described in, for example, "On the Design of Low-Density Parity-Check Codes within 0.0045 dB of the Shannon Limit", S. Y. Chung, G. D. Forney, T. J. Richardson, R. Urbanke, IEEE Communications Leggers, VOL. 5, NO. 2, Feb 2001.

In the simulation for obtaining (the parity check matrix of) the new LDPC code, an ensemble in which the performance threshold at which the BER starts to drop (becomes smaller) $E_b/N_0$ becomes a predetermined value or less is found by the multi edge type density evolution, and the LDPC code that reduces the BER in the case of using one or more orthogonal modulations such as DBPSK can be selected as the LDPC code with high performance from among the LDPC codes belonging to the ensemble.

As (the parity check matrix initial value table representing the parity check matrix of) the new LDPC code, an LDPC code with high performance obtained by the above simulation can be adopted.

According to the new LDPC code obtained by such simulation, good communication quality can be secured in data transmission.

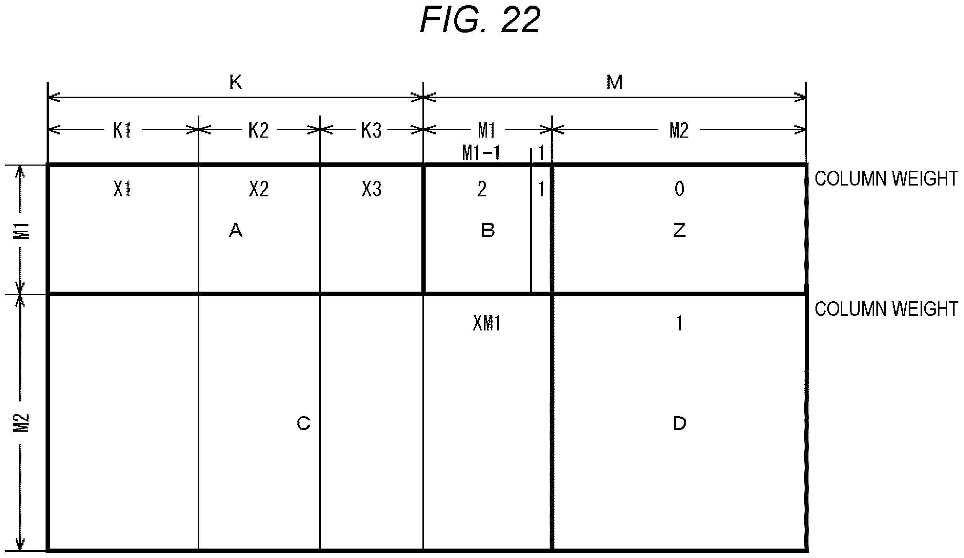

Fig. 22 is a diagram for explaining column weights of a parity check matrix H of a type A code as a new LDPC code.

For the parity check matrix H of the type A code, as illustrated in Fig. 22, the column weight of K1 columns from the first column of the A matrix and the C matrix is represented as X1, the column weight of K2 columns after the A matrix and the C matrix is represented as X2, the column weight of K3 columns after the A matrix and the C matrix is represented as X3, and the column weight of M1 columns after the C matrix is represented as XM1.

Note that K1 + K2 + K3 is equal to the information length K.

Furthermore, for the parity check matrix H of the type A code, the column weight of M1 - 1 columns from the first column of the B matrix is 2, and the column weight of the M1 column (last column) of the B matrix is 1. Moreover, a column weight of the D matrix is 1, and a column weight of the Z matrix is 0.

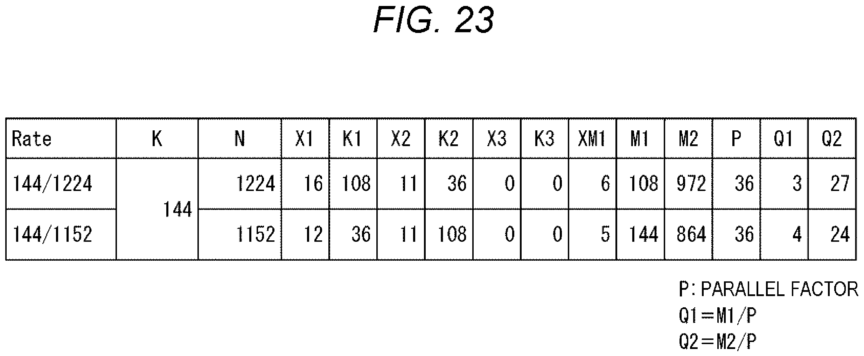

Fig. 23 is a diagram illustrating parameters of (the parity check matrix of) the type A code as the new LDPC code (represented by the parity check matrix initial value table) in Figs. 18 and 19.

The information length K, the code length N, X1, K1, X2, K2, X3, K3, XM1, M1, and M2, the parallel factor P, and Q1 = M1/P and Q2 = M2/P as parameters of the new LDPC code with the coding rate r = 144/1224 in Fig. 18 and the new LDPC code with the coding rate r = 144/1152 in Fig. 19 are as illustrated in Fig. 23. Q1 and Q2 represent the number of shifts of the cyclic shift as described with reference to Fig. 11.

<Performance of New LDPC Code>

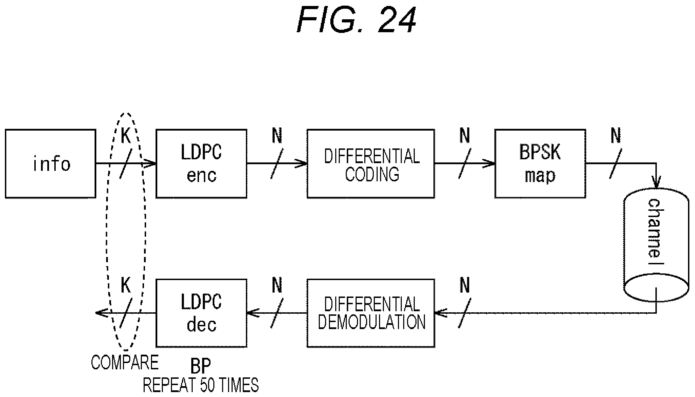

Fig. 24 is a diagram for explaining a simulation method for evaluating performance of a new LDPC code.

In the simulation, an L0 carrier is generated by performing DBPSK modulation by performing LDPC coding (LDPC enc) on information bits (info) as L0 data to a new LDPC code, performing differential coding on each bit of the new LDPC code, and mapping (BPSK map) output bits output by the differential coding to signal points of BPSK on the IQ constellation.

The differential coding is a process of obtaining an EXOR of a bit of the new LDPC code and an output bit output immediately before by the differential coding and using the EXOR as a current output bit. The initial value of the output bit is, for example, 0.

In the simulation, the L0 carrier is further differentially demodulated after passing through an AWGN channel (channel), and LDPC decoding (LDPC dec) of the LDPC code obtained by the differential demodulation is performed to restore the information bits as the L0 data. The number of repetitions of decoding in LDPC decoding is 50.

In the simulation, the FER serving as an index for evaluating the performance of the new LDPC code is calculated by comparing the restoration result of the information bits as the L0 data with the original information bits.

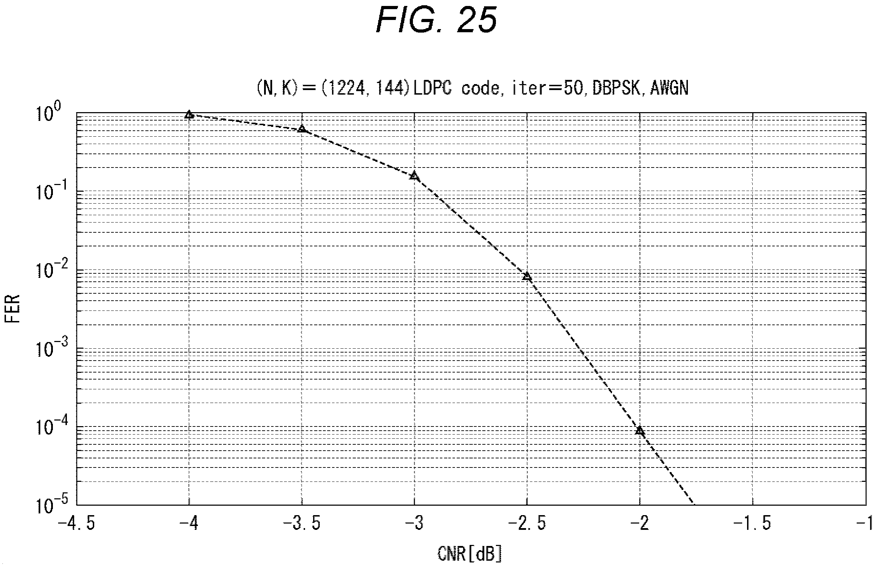

Fig. 25 is a diagram illustrating a simulation result of FER in a case where the new LDPC code with the coding rate r = 144/1224 in Fig. 18 is used.

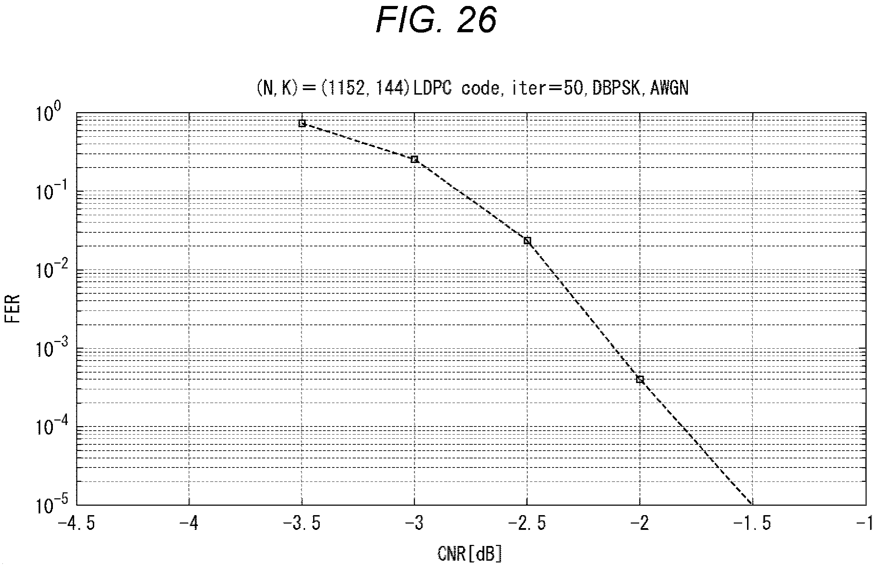

Fig. 26 is a diagram illustrating a simulation result of FER in a case where the new LDPC code with the coding rate r = 144/1152 in Fig. 19 is used.

In Figs. 25 and 26, the horizontal axis represents CNR, and the vertical axis represents FER.

As one measure of the performance of the LDPC code that transmits the L0 data as the emergency information, it is desirable that the CNR that realizes FER = 10 ^ -4 is -1.7 dB or less, particularly -2.0 dB or less.

According to Figs. 25 and 26, it can be confirmed that CNR of -2.0 dB or less can be realized in the new LDPC code with the coding rate r = 144/1224, and CNR of - 1.7 dB or less can be realized in the new LDPC code with the coding rate r = 144/1152.

Note that, in the present embodiment, in order to make the description easy to understand, the parity check matrix is obtained from the parity check matrix initial value table, and the LDPC coding is performed using the parity check matrix. However, since the parity check matrix initial value table is information equivalent to the parity check matrix, the LDPC coding (calculation of parity bits of the LDPC code) can be performed by a predetermined operation using the parity check matrix initial value table without obtaining the parity check matrix.

<Configuration Example of Reception Device 12>

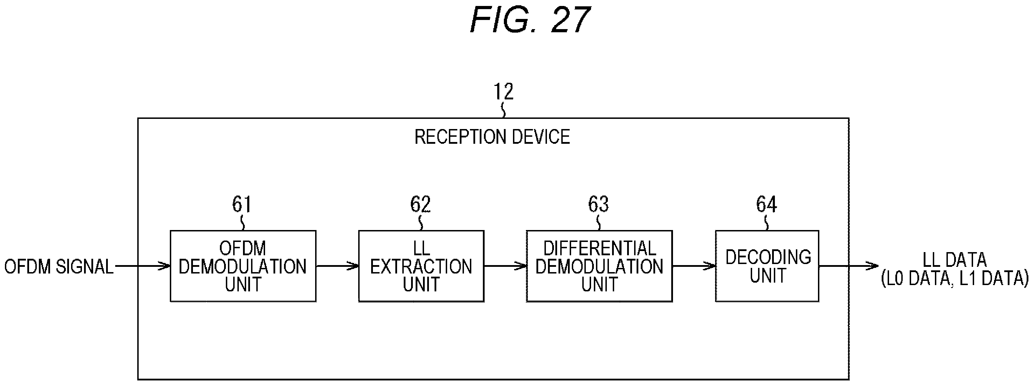

Fig. 27 is a block diagram illustrating a configuration example of the reception device 12 in Fig. 1.

The reception device 12 includes an OFDM demodulation unit 61, an LL extraction unit 62, a differential demodulation unit 63, and a decoding unit 64.

The OFDM demodulation unit 61 receives the OFDM signal from the transmission device 11. The OFDM demodulation unit 61 demodulates the OFDM signal by analog to digital (AD) conversion, quadrature demodulation, FFT, or the like, and outputs a demodulation signal obtained as a result.

The demodulation signal output from the OFDM demodulation unit 61 is supplied to the LL extraction unit 62 and to a circuit (not illustrated). In the circuit (not illustrated), carriers other than the L0 carrier and the L1 carrier included in the demodulation signal, for example, a TMCC carrier, a pilot carrier, a main data carrier, and the like are processed.

The LL extraction unit 62 extracts the L0 carrier and the L1 carrier from the demodulation signal from the OFDM demodulation unit 61, and supplies the L0 carrier and the L1 carrier to the differential demodulation unit 63.

The differential demodulation unit 63 performs differential demodulation on each of the L0 carrier and the L1 carrier from the LL extraction unit 62, and supplies the likelihood (received LLR) of each bit of the LDPC code of each of the L0 data and the L1 data obtained by the differential demodulation to the decoding unit 64.

The decoding unit 64 performs LDPC decoding of the likelihood of each bit of the LDPC code of each of the L0 data and the L1 data from the differential demodulation unit 63, and outputs the L0 data and the L1 data obtained as a result.

Note that the LDPC decoding in the decoding unit 64 can be performed using the parity check matrix itself used for the LDPC coding, or can be performed using a transformed parity check matrix obtained by performing at least column permutation corresponding to parity interleaving for the parity check matrix by the type B method used for the LDPC coding or a transformed parity check matrix (Fig. 17) obtained by performing row permutation for the parity check matrix by the type A method (Fig. 15) used for the LDPC coding.

In a case where the LDPC decoding is performed using the transformed parity check matrix, an architecture in which the check node operation and the variable node operation are simultaneously performed as many as P or less which is a parallel factor can be adopted for the LDPC decoding.

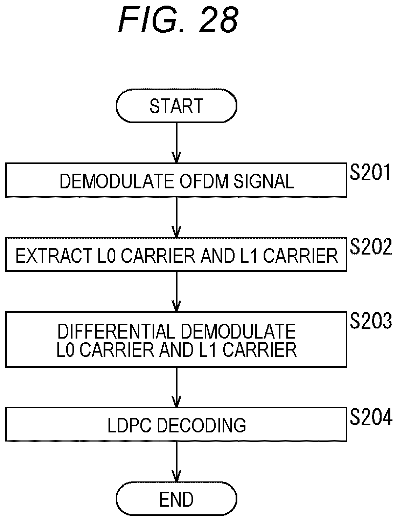

Fig. 28 is a flowchart for explaining an example of processing of the reception device 12 in Fig. 27.

In step S201, the OFDM demodulation unit 61 receives and demodulates the OFDM signal from the transmission device 11. The OFDM demodulation unit 61 supplies the demodulation signal obtained as a result of the demodulation of the OFDM signal to the LL extraction unit 62 (and the circuit (not illustrated)), and the processing proceeds from step S201 to step S202.

In step S202, the LL extraction unit 62 extracts the L0 carrier and the L1 carrier from the demodulation signal from the OFDM demodulation unit 61 and supplies the L0 carrier and the L1 carrier to the differential demodulation unit 63, and the processing proceeds to step S203.

In step S203, the differential demodulation unit 63 performs differential demodulation of each of the L0 carrier and the L1 carrier from the LL extraction unit 62, and supplies the likelihood of each bit of the LDPC code of each of the L0 data and the L1 data obtained by the differential demodulation to the decoding unit 64, and the processing proceeds to step S204.

In step S204, the decoding unit 64 performs LDPC decoding of the likelihood of each bit of the LDPC code of each of the L0 data and the L1 data from the differential demodulation unit 63, and outputs the L0 data and the L1 data obtained as a result.

<LDPC Decoding>

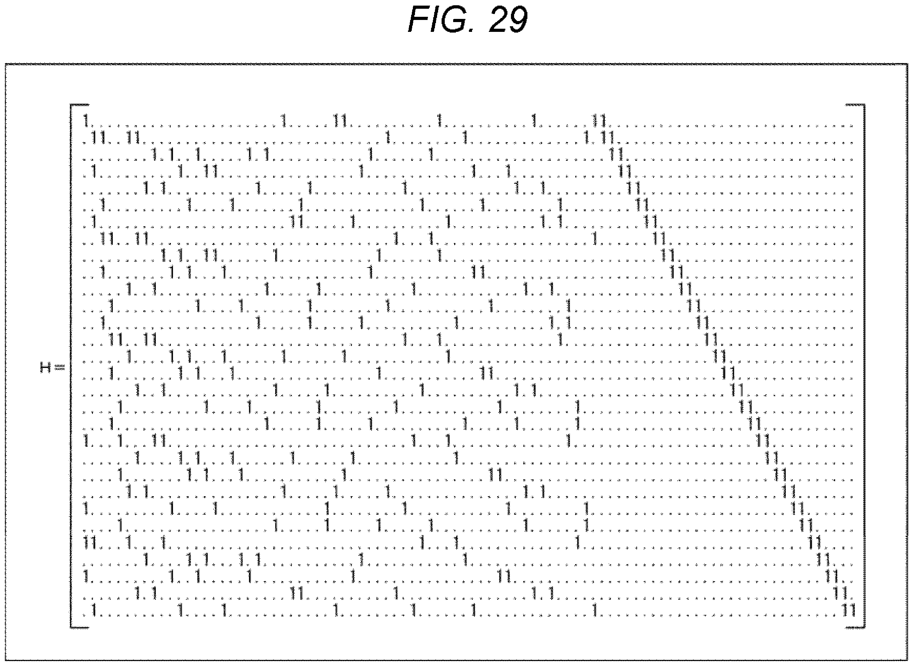

Figs. 29 to 32 are diagrams for explaining LDPC decoding using a transformed parity check matrix performed by the decoding unit 64 in Fig. 27.

The decoding unit 64 in Fig. 27 can perform LDPC decoding by using a transformed parity check matrix obtained by performing at least column permutation corresponding to parity interleaving for the parity check matrix H by the type B method used for LDPC coding by the encoding unit 21 in Fig. 2 or a transformed parity check matrix (Fig. 17) obtained by performing row permutation for the parity check matrix (Fig. 15) by the type A method.

Here, LDPC decoding that can suppress an operation frequency within a sufficiently feasible range while suppressing a circuit scale by performing LDPC decoding using a transformed parity check matrix has been previously proposed (see, for example, Japanese Patent No. 4224777).

LDPC decoding using a transformed parity check matrix, which has been previously proposed, will be described with reference to Figs. 29 to 32.

Fig. 29 is a diagram illustrating an example of a parity check matrix H of an LDPC code as a type B code with a code length N of 90 and a coding rate of 2/3.

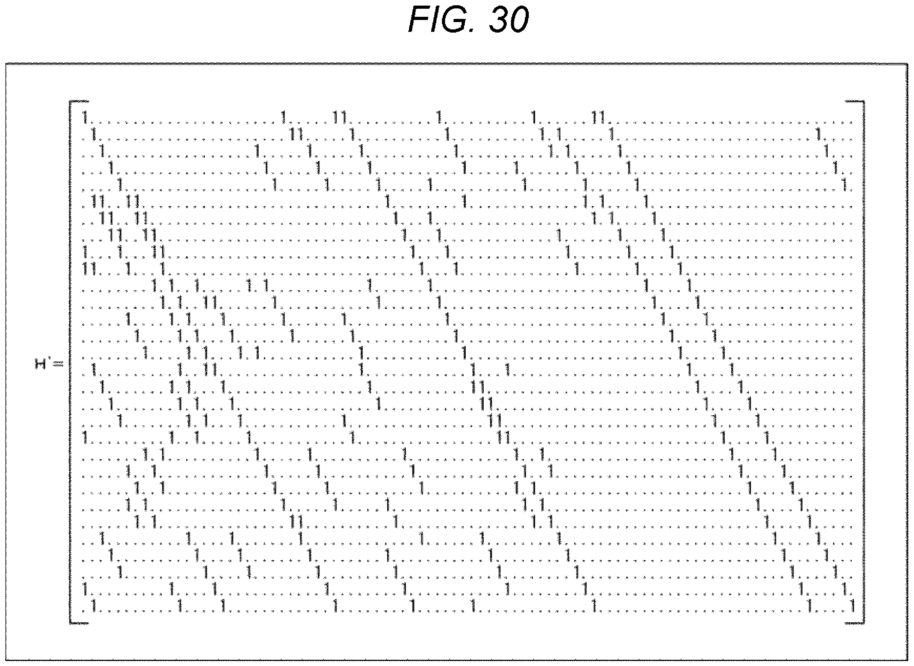

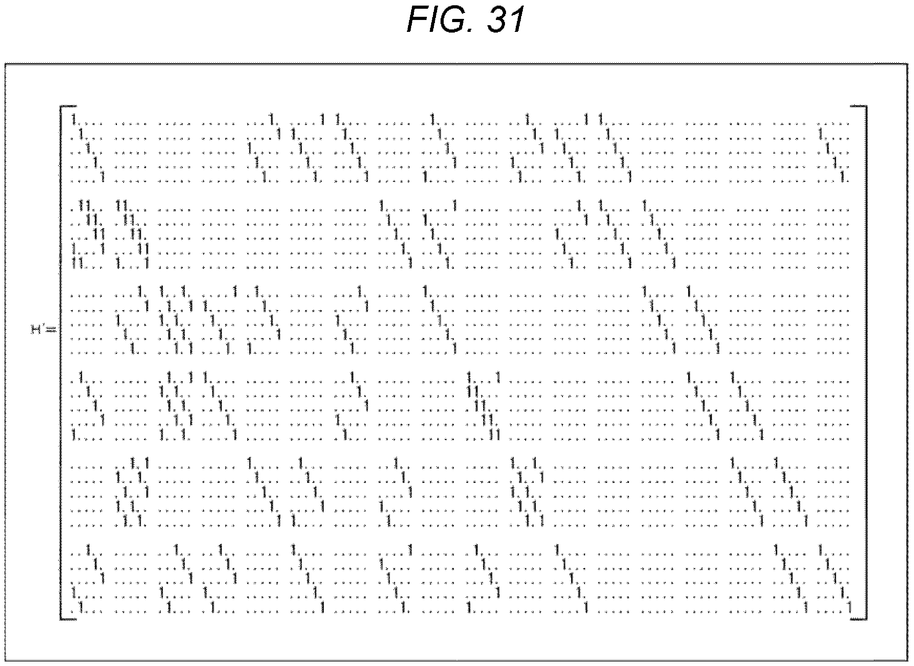

Note that, in Fig. 29 (also similarly in to Figs. 30 and 31 described later), 0 is expressed by a period (.).

In the parity check matrix H in Fig. 29, the parity matrix has a staircase structure.

Fig. 30 is a diagram illustrating a parity check matrix H' obtained by applying the row permutation of the equation (4) and the column permutation of the equation (5) to the parity check matrix H in Fig. 29.

$$\text{Row permutation: }(6s+t+1)\text{th row}\rightarrow(5t+s+1)\text{th row} \quad (4)$$

$$\text{Column permutation: }(6x+y+61)\text{th column}\rightarrow(5y+x+61)\text{th column} \quad (5)$$

In equations (4) and (5), s, t, x, and y are integers in ranges of $0 \leq s < 5$, $0 \leq t < 6$, $0 \leq x < 5$, and $0 \leq y < 6$, respectively.

According to the row permutation of the equation (4), permutation is performed in such a manner that the first, seventh, 13th, 19th, and 25th rows where the remainder becomes 1 when being divided by 6 are respectively permutated to the first, second, third, fourth, and fifth rows, and the second, eighth, 14th, 20th, and 26th rows where the remainder becomes 2 when being divided by 6 are respectively permutated to the sixth, seventh, eighth, ninth, and 10th rows.

Furthermore, according to the column permutation of the equation (5), for the 61st and subsequent columns (parity matrix), permutation is performed in such a manner that the 61st, 67th, 73rd, 79th, and 85th columns where the remainder becomes 1 when being divided by 6 are respectively permutated to the 61st, 62nd, 63rd, 64th, and 65th columns, and the 62nd, 68th, 74th, 80th, and 86th columns where the remainder becomes 2 when being divided by 6 are respectively permutated to the 66th, 67th, 68th, 69th, and 70th columns.

In this way, a matrix obtained by performing row and column permutation for the parity check matrix H in Fig. 29 is the parity check matrix H' in Fig. 30.

Here, the row permutation of the parity check matrix H does not affect the arrangement of the sign bits of the LDPC code.

Furthermore, the column permutation of the equation (5) corresponds to the parity interleaving when the information length K is 60, the parallel factor P is 5, and the divisor q (= M/P) of the parity length M (here, 30) is 6 in the parity interleaving of interleaving the (K + qx + y + 1)th sign bit described above to the position of the (K + Py + x + 1)th sign bit.

The parity check matrix H' in Fig. 30 is a transformed parity check matrix obtained by performing at least column permutation for permutating the (K + qx + y + 1)th column to the (K + Py + x + 1)th column in the parity check matrix (hereinafter, the original parity check matrix is appropriately referred to as an original parity check matrix) H in Fig. 29.

When multiplying the transformed parity check matrix H' in Fig. 30 by a resultant obtained by performing the same permutation as the equation (5) for the LDPC code of the original parity check matrix H in Fig. 29, a 0 vector is output. That is, when a row vector obtained by applying the column permutation of the equation (5) to the row vector c as the LDPC code (one code word) of the original parity check matrix H is represented as c', $Hc^T$ is a 0 vector due to the property of the parity check matrix, and thus $H'c'^T$ is also a 0 vector as a matter of course.

From the above, the transformed parity check matrix H' in Fig. 30 is a parity check matrix of the LDPC code c' obtained by performing the column permutation of the equation (5) for the LDPC code c of the original parity check matrix H.

Therefore, by performing the column permutation of the equation (5) for the LDPC code c of the original parity check matrix H, decoding (LDPC decoding) the LDPC code c' after the column permutation using the transformed parity check matrix H' in Fig. 30, and applying the inverse permutation of the column permutation of the equation (5) to the decoding result, a decoding result similar to the case of decoding the LDPC code of the original parity check matrix H using the parity check matrix H can be obtained.

Fig. 31 is a diagram illustrating the transformed parity check matrix H' in Fig. 30 spaced in units of a 5 × 5 matrix.

In Fig. 31, the transformed parity check matrix H' is represented by a combination of a 5 × 5 (= P × P) identity matrix that is the parallel factor P, a matrix in which one or more of 1's of the identity matrix are 0 (hereinafter, the matrix is appropriately referred to as a quasi identity matrix), a matrix obtained by cyclically shifting the identity matrix or the quasi identity matrix (hereinafter, the matrix is appropriately referred to as a shift matrix), a sum of 2 or more of the identity matrix, the quasi identity matrix, or the shift matrix (hereinafter, the matrix is appropriately referred to as a sum matrix), and a 5 × 5 0 matrix.

It can be said that the transformed parity check matrix H' in Fig. 31 includes a 5 × 5 identity matrix, a quasi identity matrix, a shift matrix, a sum matrix, and a 0 matrix. Therefore, these 5 × 5 matrices (identity matrix, quasi identity matrix, shift matrix, sum matrix, and zero matrix) constituting the transformed parity check matrix H' are hereinafter appropriately referred to as configuration matrices.

An architecture that simultaneously performs P check node operations and variable node operations can be used to decode the LDPC code of the parity check matrix represented by the P × P configuration matrix.

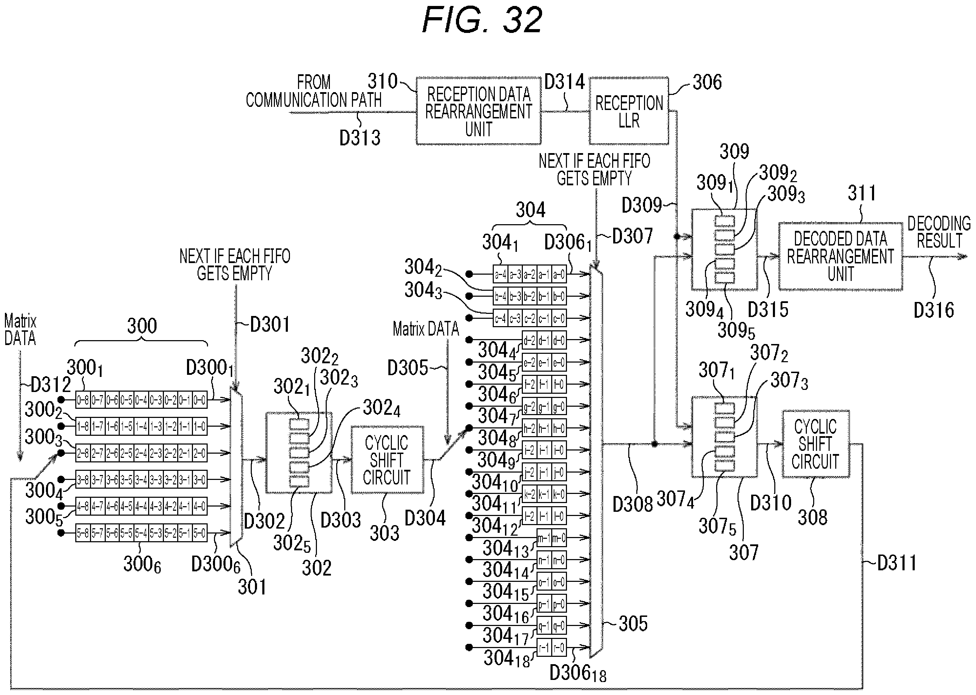

Fig. 32 is a block diagram illustrating a configuration example of a decoding device that performs such decoding.

In other words, Fig. 32 illustrates a configuration example of a decoding device that decodes the LDPC code using the transformed parity check matrix H' in Fig. 31 obtained by performing at least the column permutation of the equation (5) for the original parity check matrix H in Fig. 29.

The decoding device in Fig. 32 includes an edge data storage memory 300 including six FIFOs $300_1$ to $300_6$, a selector 301 for selecting the FIFOs $300_1$ to $300_6$, a check node calculation unit 302, two cyclic shift circuits 303 and 308, an edge data storage memory 304 including 18 FIFOs $304_1$ to $304_{18}$, a selector 305 for selecting the FIFOs $304_1$ to $304_{18}$, a reception data memory 306 for storing reception data, a variable node calculation unit 307, a decoded word calculation unit 309, a reception data rearrangement unit 310, and a decoded data rearrangement unit 311.

First, a method of storing data in the edge data storage memories 300 and 304 will be described.

The edge data storage memory 300 includes six FIFOs $300_1$ to $300_6$ which are the number obtained by dividing the number of rows 30 of the transformed parity check matrix H' in Fig. 31 by the number of rows (parallel factor P) 5 of the configuration matrix. The FIFO $300_y$ (y = 1, 2, ..., 6) includes storage areas of a plurality of stages, and messages corresponding to five edges, which are the number of rows and the number of columns (parallel factor P) of the configuration matrix, can be simultaneously read and written for the storage areas of the respective stages. Furthermore, the number of stages of the storage areas in the FIFO $300_y$ is 9, which is the maximum number of 1s (hamming weights) in the row direction of the transformed parity check matrix in Fig. 31.

In the FIFO $300_1$, data (messages v from the variable nodes) corresponding to the positions of 1 of the first to fifth rows of the transformed parity check matrix H' in Fig. 31 is stored close to each other (ignoring 0) in the horizontal direction for each row. That is, if the j-th row and the i-th column are represented as (j, i), data corresponding to the positions of 1 of the 5 × 5 identity matrix of (1, 1) to (5, 5) of the transformed parity check matrix H' is stored in the storage area of the first stage of the FIFO $300_1$. Data corresponding to the positions of 1 of the shift matrix of (1, 21) to (5, 25) of the transformed parity check matrix H' (the shift matrix obtained by cyclically shifting the 5 × 5 identity matrix rightward by three) is stored in the storage area of the second stage. Similarly, data is stored in the storage areas of the third to eighth stages according to the transformed parity check matrix H'. Then, data corresponding to the positions of 1 of the shift matrix (1 in the first row of the 5 × 5 identity matrix is replaced with 0, and the shifted matrix is cyclically shifted to the left by 1) of from (1, 86) to (5, 90) of the transformed parity check matrix H' is stored in the storage area of the ninth stage.

Data corresponding to the positions of 1 of the sixth to 10th rows of the transformed parity check matrix H' in Fig. 31 is stored in the FIFO $300_2$. In other words, data corresponding to the positions of 1 of the first shift matrix constituting the sum matrix (a sum matrix which is a sum of a first shift matrix obtained by cyclically shifting the 5 × 5 identity matrix to the right by one and a second shift matrix obtained by cyclically shifting the 5 × 5 identity matrix to the right by two) of (6, 1) to (10, 5) of the transformed parity check matrix H' is stored in the storage area of the first stage of the FIFO $300_2$. Furthermore, data corresponding to the positions of 1 of the second shift matrix constituting the sum matrix of (6, 1) to (10, 5) of the transformed parity check matrix H' is stored in the storage area of the second stage.

In other words, for a configuration matrix having a weight of 2 or more, when the configuration matrix is expressed in the form of a sum of some matrices of a P × P identity matrix having a weight of 1, a quasi identity matrix in which one or more of the elements of 1 of the identity matrix are 0, and a shift matrix obtained by cyclically shifting the identity matrix or the quasi identity matrix, data (message corresponding to edge belonging to identity matrix, quasi identity matrix, or shift matrix) corresponding to the position of 1 of the identity matrix having a weight of 1, the quasi identity matrix, or the shift matrix is stored in storage areas of different stages of the same address (the same FIFO among the FIFOs $300_1$ to $300_6$).

Hereinafter, data is also stored in the storage areas of the third to ninth stages according to the transformed parity check matrix H'.

Similarly, the FIFOs $300_3$ to $300_6$ store data according to the transformed parity check matrix H'.

The edge data storage memory 304 includes 18 FIFOs $304_1$ to $304_{18}$ obtained by dividing the number of columns 90 of the transformed parity check matrix H' by the number of columns (parallel factor P) 5 of the configuration matrix. The FIFO $304_x$ (x = 1, 2, ..., 18) includes storage areas of a plurality of stages, and messages corresponding to five edges, which are the number of rows and the number of columns (parallel factor P) of the configuration matrix, can be simultaneously read and written for the storage areas of the respective stages.

In the FIFO $304_1$, data (message u from the check node) corresponding to the positions of 1 of the first to fifth columns of the transformed parity check matrix H' in Fig. 31 is stored close to each other (ignoring 0) in the vertical direction for each column. That is, data corresponding to the positions of 1 of the 5 × 5 identity matrix of (1, 1) to (5, 5) of the transformed parity check matrix H' is stored in the storage area of the first stage of the FIFO $304_1$. Data corresponding to the positions of 1 of the first shift matrix constituting the sum matrix (a sum matrix that is a sum of a first shift matrix obtained by cyclically shifting the 5 × 5 identity matrix to the right by one and a second shift matrix obtained by cyclically shifting the 5 × 5 identity matrix to the right by two) of (6, 1) to (10, 5) of the transformed parity check matrix H' is stored in the storage area of the second stage. Furthermore, data corresponding to the positions of 1 of the second shift matrix constituting the sum matrix of (6, 1) to (10, 5) of the transformed parity check matrix H' is stored in the storage area of the third stage.

In other words, for a configuration matrix having a weight of 2 or more, when the configuration matrix is expressed in the form of a sum of some matrices of a P × P identity matrix having a weight of 1, a quasi identity matrix in which one or more of the elements of 1 of the identity matrix are 0, and a shift matrix obtained by cyclically shifting the identity matrix or the quasi identity matrix, data (message corresponding to edge belonging to identity matrix, quasi identity matrix, or shift matrix) corresponding to the position of 1 of the identity matrix having a weight of 1, the quasi identity matrix, or the shift matrix is stored in storage areas of different stages of the same address (the same FIFO among the FIFOs $304_1$ to $304_{18}$).

Hereinafter, data is also stored in the storage areas of the fourth and fifth stages according to the transformed parity check matrix H'. The number of stages of the storage areas of the FIFO $304_1$ is 5, which is the maximum number of 1's (column weights) in the column direction in the first to fifth columns of the transformed parity check matrix H'.

Similarly, the FIFOs $304_2$ and $304_3$ store data according to the transformed parity check matrix H', and the length (the number of stages) of each is 5. Similarly, the FIFOs $304_4$ to $304_{12}$ store data according to the transformed parity check matrix H', and each have a length of 3. Similarly, the FIFOs $304_{13}$ to $304_{18}$ store data according to the transformed parity check matrix H', and each have a length of 2.

Next, an operation of the decoding device in Fig. 32 will be described.

The edge data storage memory 300 includes six FIFOs $300_1$ to $300_6$, and selects a FIFO to store data from among the FIFOs $300_1$ to $300_6$ according to information (matrix data) D312 indicating to which row of the transformed parity check matrix H' in Fig. 31 the five messages D311 supplied from the previous cyclic shift circuit 308 belong, and collectively stores the five messages D311 in the selected FIFO in order. Furthermore, when reading data, the edge data storage memory 300 sequentially reads five messages $D300_1$ from the FIFO $300_1$ and supplies the messages to the selector 301 of the next stage. After completion of reading of the message from the FIFO $300_1$, the edge data storage memory 300 sequentially reads the messages from the FIFOs $300_2$ to $300_6$ and supplies the messages to the selector 301.

In accordance with the select signal D301, the selector 301 selects five messages from the FIFO from which data is currently read out among the FIFOs $300_1$ to $300_6$, and supplies the selected messages as messages D302 to the check node calculation unit 302.

The check node calculation unit 302 includes five check node calculators $302_1$ to $302_5$, performs a check node operation using the messages D302 ($D302_1$ to $D302_5$) (messages v from the variable nodes) supplied through the selector 301, and supplies five messages D303 ($D303_1$ to $D303_5$) (messages u from the check nodes) obtained as a result of the check node operation to the cyclic shift circuit 303.

The cyclic shift circuit 303 cyclically shifts the five messages $D303_1$ to $D303_5$ obtained by the check node calculation unit 302 on the basis of information indicating how many identity matrices (or quasi identity matrices) as the basis in the transformed parity check matrix H' have been cyclically shifted for the corresponding edge, and supplies the result as a message D304 to the edge data storage memory 304.

The edge data storage memory 304 includes 18 FIFOs $304_1$ to $304_{18}$, selects a FIFO to store data from among the FIFOs $304_1$ to $304_{18}$ according to information D305 (matrix data) as to which row of the transformed parity check matrix H' five messages D304 supplied from the previous cyclic shift circuit 303 belong, and collectively stores the five messages D304 in the selected FIFO in order. Furthermore, when reading data, the edge data storage memory 304 sequentially reads five messages $D306_1$ from the FIFO $304_1$ and supplies the messages to the selector 305 of the next stage. After completion of reading data from the FIFO $304_1$, the edge data storage memory 304 sequentially reads messages from the FIFOs $304_2$ to $304_{18}$ and supplies the messages to the selector 305.

In accordance with the select signal D307, the selector 305 selects five messages from the FIFO from which data is currently read out among the FIFOs $304_1$ to $304_{18}$, and supplies the selected messages as messages D308 to the variable node calculation unit 307 and the decoded word calculation unit 309.

On the other hand, the reception data rearrangement unit 310 rearranges the LDPC code D313 corresponding to the parity check matrix H in Fig. 29 supplied to the decoding device by performing the column permutation of the equation (5), and supplies the rearranged LDPC code as the reception data D314 to the reception data memory 306. The reception data memory 306 calculates and stores reception LLRs (log likelihood ratios) from the reception data D314 supplied from the reception data rearrangement unit 310, and supplies the five reception LLRs collectively as a reception value D309 to the variable node calculation unit 307 and the decoded word calculation unit 309.

The variable node calculation unit 307 includes five variable node calculators $307_1$ to $307_5$, performs a variable node operation using the messages D308 ($D308_1$ to $D308_5$) (messages u from the check nodes) supplied through the selector 305 and the five reception values D309 supplied from the reception data memory 306, and supplies messages D310 ($D310_1$ to $D310_5$) (messages v from the variable nodes) obtained as a result of the operation to the cyclic shift circuit 308.

The cyclic shift circuit 308 cyclically shifts the messages $D310_1$ to $D310_5$ calculated by the variable node calculation unit 307 on the basis of information indicating how many identity matrices (or quasi identity matrices) as the basis in the transformed parity check matrix H' have been cyclically shifted for the corresponding edge, and supplies the result as a message D311 to the edge data storage memory 300.

By making one round of the above operation, one decoding (variable node operation and check node operation) of the LDPC code can be performed. The decoding device in Fig. 32 decodes the LDPC code a predetermined number of times of iterative decoding, and then obtains and outputs a final decoding result in the decoded word calculation unit 309 and the decoded data rearrangement unit 311.

That is, the decoded word calculation unit 309 includes five decoded word calculators $309_1$ to $309_5$, calculates a decoding result (decoded word) by performing an operation similar to the variable node operation as a final stage of a plurality of times of decoding using five messages D308 ($D308_1$ to $D308_5$) (messages u from the check node) output by the selector 305 and five reception values D309 supplied from the reception data memory 306, and supplies decoded data D315 obtained as a result to the decoded data rearrangement unit 311.

The decoded data rearrangement unit 311 rearranges the order of the decoded data D315 supplied from the decoded word calculation unit 309 by performing inverse permutation of the column permutation of the equation (5), and outputs a final decoding result D316.

As described above, by performing one or both of the row permutation and the column permutation for the parity check matrix (original parity check matrix) and converting the parity check matrix (original parity check matrix) into a parity check matrix (transformed parity check matrix) that can be represented by a $P \times P$ constitutive matrix, an architecture that simultaneously performs P node operations (check node operations and variable node operations), the number of which is smaller than the number of rows and the number of columns of the parity check matrix, can be adopted in the LDPC decoding. In a case of adopting an architecture that simultaneously performs P node operations, the number of which is smaller than the number of rows and the number of columns of the parity check matrix, it is possible to perform a large number of iterative decoding while suppressing the operation frequency to a feasible range.

The decoding unit 64 included in the reception device 12 of Fig. 27 can perform LDPC decoding for simultaneously executing P node operations, for example, similarly to the decoding device of Fig. 32.

Here, the parity check matrix of the LDPC code output by the encoding unit 21 constituting the transmission device 11 is, for example, the parity check matrix H illustrated in Fig. 29, and parity interleaving is performed in the encoding unit 21.

In this case, the parity interleaving performed by the encoding unit 21 is parity interleaving that is performed by setting the information length K to 60, the parallel factor P to 5, and the divisor q (= M/P) of the parity length M to 6, and interleaves the (K + qx + y + 1)th sign bit to the position of the (K + Py + x + 1)th sign bit.

Since this parity interleaving corresponds to the column permutation of the equation (5) as described in the equation (5), the LDPC code that has been subjected to the LDPC coding using the parity check matrix H and has been subjected to the parity interleaving has already been subjected to the column permutation of the equation (5) .

Therefore, in a case where the LDPC decoding of the LDPC code that has been subjected to the LDPC coding using the parity check matrix H and has been subjected to the parity interleaving is performed using the transformed parity check matrix H' obtained by performing the column permutation of the equation (5), it is not necessary to perform the column permutation of the equation (5) for the LDPC code.

Further, there is no need to perform parity deinterleaving for restoring the parity interleaving of the LDPC code before the LDPC decoding.

In a case where the parity interleaving is not performed on the LDPC code, the decoding unit 64 can be configured similarly to the decoding device in Fig. 32. On the other hand, in a case where the parity interleaving is applied to the LDPC code, the decoding unit 64 can be configured not to perform the column permutation of the equation (5) for the LDPC code in the decoding device of Fig. 32.

Although the type A code has been described above as an example, it similarly applies to the type B code.

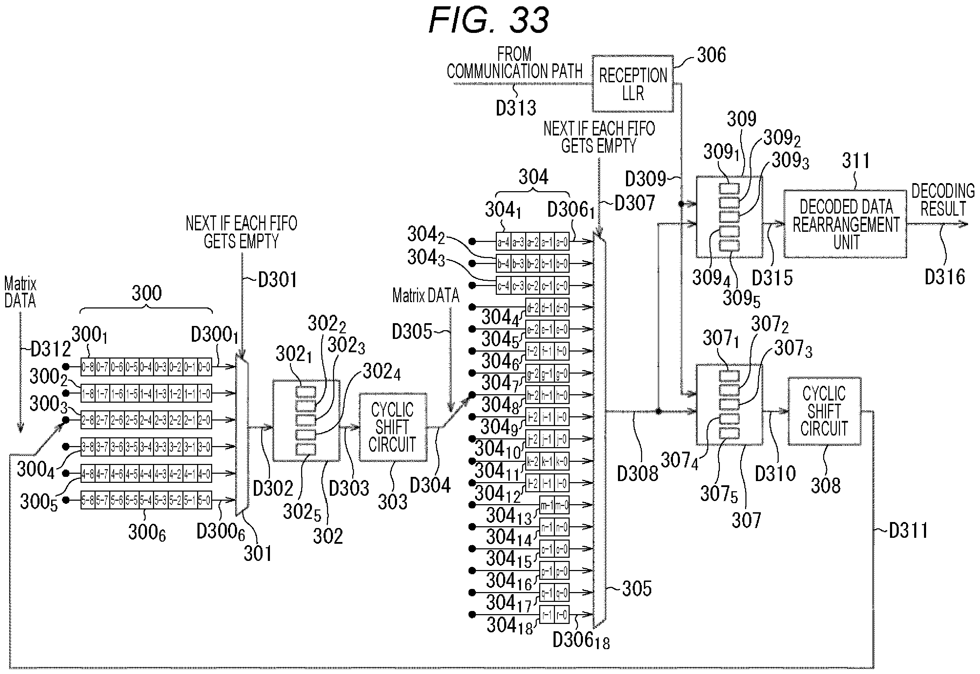

Fig. 33 is a diagram illustrating a configuration example of the decoding unit 64 in Fig. 27 in a case where parity interleaving is applied to the LDPC code.

In Fig. 33, the decoding unit 64 is configured similarly to the decoding device in Fig. 32 except that the reception data rearrangement unit 310 in Fig. 32 is not provided, and performs similar processing to the decoding device in Fig. 32 except that the column permutation of the equation (5) is not performed, and thus the description thereof is omitted. Note that a portion for performing LDPC decoding for each of the LDPC codes of the L0 data and the L1 data can be separately provided in the decoding unit 64.

As described above, since the decoding unit 64 can be configured without the reception data rearrangement unit 310, the scale can be reduced as compared with the decoding device in Fig. 32.

Note that, in Figs. 29 to 33, in order to simplify the description, the code length N of the LDPC code is set to 90, the information length K is set to 60, and the parallel factor (the number of rows and the number of columns of the configuration matrix) P is set to 5. However, each of the code length N, the information length K, and the parallel factor P is not limited to the above-described values.

That is, in the transmission device 11 in Fig. 2, what the encoding unit 21 outputs is the new LDPC code described with reference to Figs. 18 and 19, but the decoding unit 64 in Fig. 33 can be applied to a case of performing LDPC decoding by performing P node operations at the same time for such a new LDPC code.

Further, after the decoding of the LDPC code in the decoding unit 64, the parity portion of the decoding result is unnecessary, and in a case where only the information bits of the decoding result are output, the decoding unit 64 can be configured without the decoded data rearrangement unit 311.

<Embodiment of Computer>

Next, the series of processes described above can be performed by hardware or also performed by software. In a case where the series of processes is performed by the software, a program constituting the software is installed on a general-purpose computer, and the like.

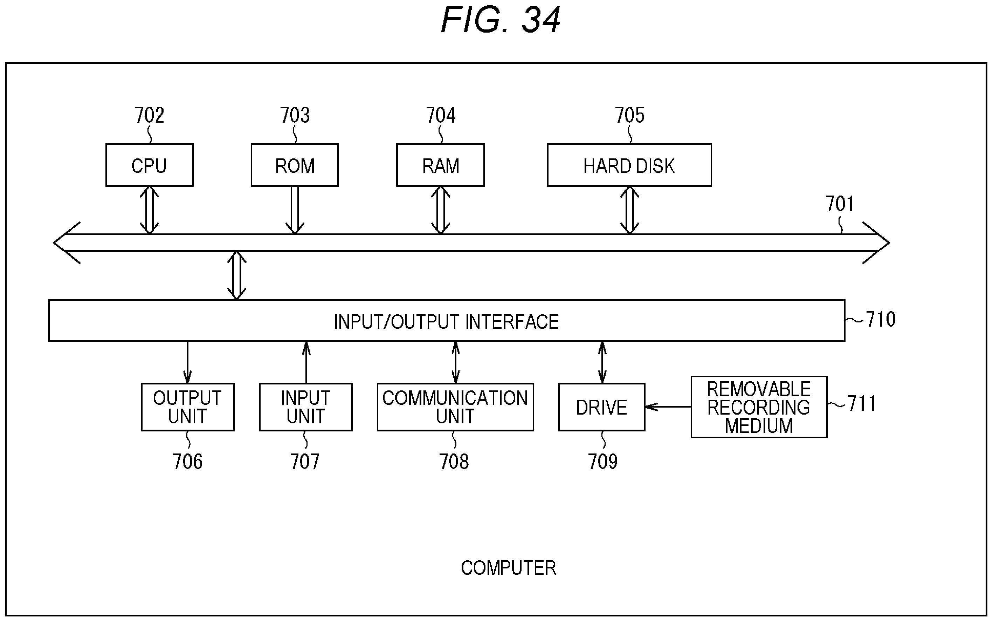

Therefore, Fig. 34 illustrates a configuration example of an embodiment of a computer in which a program for executing the series of processes described above is installed.

The program can be recorded in advance in a hard disk 705 or a ROM 703 as a recording medium built in the computer.

Alternatively, the program can be temporarily or permanently stored (recorded) in a removable recording medium 711 such as a flexible disk, a compact disc read only memory (CD-ROM), a magneto optical (MO) disk, a digital versatile disc (DVD), a magnetic disk, or a semiconductor memory. Such a removable recording medium 711 can be provided as so-called packaged software.

Note that the program can be installed from the removable recording medium 711 to the computer as described above, can be wirelessly transferred from a download site to the computer via an artificial satellite for digital satellite broadcasting, or can be transferred by wire to the computer via a network such as a local area network (LAN) or the Internet, and the program thus transferred can be received by the communication unit 708 and installed in the built-in hard disk 705 in the computer.

The computer includes a built-in central processing unit (CPU) 702. An input/output interface 710 is connected to the CPU 702 via a bus 701, and when a command is input by the user operating an input unit 707 including a keyboard, a mouse, a microphone, and the like via the input/output interface 710, the CPU 702 executes the program stored in the read only memory (ROM) 703 according to the command. Alternatively, the CPU 702 loads a program stored in the hard disk 705, a program transferred from a satellite or a network, received by the communication unit 708, and installed in the hard disk 705, or a program read from the removable recording medium 711 attached to the drive 709 and installed in the hard disk 705 into a random access memory (RAM) 704, and executes the program. As a result, the CPU 702 performs the processing according to the above-described flowchart or the processing performed by the configuration of the above-described block diagram. Then, the CPU 702 outputs the processing result from an output unit 706 including a liquid crystal display (LCD), a speaker, or the like, or transmits the processing result from a communication unit 708, and further records the processing result in the hard disk 705 via the input/output interface 710, for example, as necessary.

Here, in the present specification, processing steps describing a program for causing a computer to perform various processes are not necessarily processed in time series in the order described as the flowchart, and include processing executed in parallel or individually (for example, parallel processing or processing by an object).

Furthermore, the program may be processed by one computer or may be processed in a distributed manner by a plurality of computers. Moreover, the program may be transferred to a distant computer to be executed.

Note that the embodiments of the present technology are not limited to the above-described embodiments, and various changes can be made without departing from the gist of the present technology.

For example, (the parity check matrix initial value table of) the above-described new LDPC code can be used for satellite lines, terrestrial waves, cables (wired lines), and other communication paths 13 (Fig. 1). Furthermore, the new LDPC code can also be used for data transmission other than digital broadcasting.

Note that the effects described herein are merely examples and are not limited, and other effects may be provided.

REFERENCE SIGNS LIST

11 Transmission device
12 Reception device
13 Communication path
21 Encoding unit
22 DBPSK modulation unit
23 OFDM signal generation unit
31 L0 encoding unit
32 L1 encoding unit
61 OFDM demodulation unit
62 LL extraction unit
63 Differential demodulation unit
64 Decoding unit
300 Edge data storage memory
301 Selector
302 Check node calculation unit
303 Cyclic shift circuit
304 Edge data storage memory
305 Selector
306 Reception data memory
307 Variable node calculation unit
308 Cyclic shift circuit
309 Decoded word calculation unit
310 Reception data rearrangement unit
311 Decoded data rearrangement unit
701 Bus
702 CPU
703 ROM
704 RAM
705 Hard disk
706 Output unit
707 Input unit
708 Communication unit
709 Drive
710 Input/output interface

711 Removable recording medium

## Claims

**1.** A transmission device comprising

an encoding unit that performs LDPC coding on a basis of a parity check matrix of an LDPC code with a code length N of 1224 bits and a coding rate r of 144/1224,
wherein the parity check matrix includes:

an A matrix on an upper left of the parity check matrix, of M1 rows and K columns represented by a predetermined value M1 and an information length K = N × r of the LDPC code;
a B matrix of a staircase structure adjacent to a right of the A matrix, of M1 rows and M1 columns;
a Z matrix that is a zero matrix adjacent to a right of the B matrix, of M1 rows and N - K - M1 columns;
a C matrix adjacent under the A matrix and the B matrix, of N - K - M1 rows and K + M1 columns; and
a D matrix that is an identity matrix adjacent to a right of the C matrix, of N - K - M1 rows and N - K - M1 columns,
the predetermined value M1 is 108,
the A matrix and the C matrix are represented by a parity check matrix initial value table,
the parity check matrix initial value table is a table representing positions of elements of 1 of the A matrix and the C matrix for every 36 columns, and

7 36 107 167 173 350 489 510 577 643 716 789 960 979 1061 1076
53 75 103 336 349 396 414 480 488 490 513 559 610 622 827 1039
13 69 101 108 122 277 483 532 546 587 612 710 713 858 982 1025
10 32 72 282 420 441 482 553 784 808 977
139 178 778 803 813 1055
130 576 709 732 827 991
109 125 403 905 998 1068.

**2.** The transmission device according to claim 1,
wherein the LDPC code is transmitted in an orthogonal frequency-division multiplexing (OFDM) segment partially receivable.

**3.** A transmission method comprising

an encoding step of performing LDPC coding on a basis of a parity check matrix of an LDPC code with a code length N of 1224 bits and a coding rate r of 144/1224,
wherein the parity check matrix includes:

an A matrix on an upper left of the parity check matrix, of M1 rows and K columns represented by a predetermined value M1 and an information length K = N × r of the LDPC code;
a B matrix of a staircase structure adjacent to a right of the A matrix, of M1 rows and M1 columns;
a Z matrix that is a zero matrix adjacent to a right of the B matrix, of M1 rows and N - K - M1 columns;
a C matrix adjacent under the A matrix and the B matrix, of N - K - M1 rows and K + M1 columns; and
a D matrix that is an identity matrix adjacent to a right of the C matrix, of N - K - M1 rows and N - K - M1 columns,
the predetermined value M1 is 108,
the A matrix and the C matrix are represented by a parity check matrix initial value table,
the parity check matrix initial value table is a table representing positions of elements of 1 of the A matrix and the C matrix for every 36 columns, and

7 36 107 167 173 350 489 510 577 643 716 789 960 979 1061 1076
53 75 103 336 349 396 414 480 488 490 513 559 610 622 827 1039
13 69 101 108 122 277 483 532 546 587 612 710 713 858 982 1025
10 32 72 282 420 441 482 553 784 808 977
139 178 778 803 813 1055
130 576 709 732 827 991
109 125 403 905 998 1068.

**4.** A reception device comprising

a decoding unit that decodes an LDPC code obtained from data transmitted by a transmission method comprising an encoding step of performing LDPC coding on a basis of a parity check matrix of the LDPC code with a code length N of 1224 bits and a coding rate r of 144/1224,
wherein the parity check matrix includes:

an A matrix on an upper left of the parity check matrix, of M1 rows and K columns represented by a predetermined value M1 and an information length K = N $\times$ r of the LDPC code;
a B matrix of a staircase structure adjacent to a right of the A matrix, of M1 rows and M1 columns;
a Z matrix that is a zero matrix adjacent to a right of the B matrix, of M1 rows and N - K - M1 columns;
a C matrix adjacent under the A matrix and the B matrix, of N - K - M1 rows and K + M1 columns; and
a D matrix that is an identity matrix adjacent to a right of the C matrix, of N - K - M1 rows and N - K - M1 columns,
the predetermined value M1 is 108,
the A matrix and the C matrix are represented by a parity check matrix initial value table,
the parity check matrix initial value table is a table representing positions of elements of 1 of the A matrix and the C matrix for every 36 columns, and

7 36 107 167 173 350 489 510 577 643 716 789 960 979 1061 1076
53 75 103 336 349 396 414 480 488 490 513 559 610 622 827 1039
13 69 101 108 122 277 483 532 546 587 612 710 713 858 982 1025
10 32 72 282 420 441 482 553 784 808 977
139 178 778 803 813 1055
130 576 709 732 827 991
109 125 403 905 998 1068.

**5.** The reception device according to claim 4,
wherein the LDPC code is transmitted in an orthogonal frequency-division multiplexing (OFDM) segment partially receivable.

**6.** A reception method comprising

a decoding step of decoding an LDPC code obtained from data transmitted by a transmission method comprising an encoding step of performing LDPC coding on a basis of a parity check matrix of the LDPC code with a code length N of 1224 bits and a coding rate r of 144/1224,
wherein the parity check matrix includes:

an A matrix on an upper left of the parity check matrix, of M1 rows and K columns represented by a predetermined value M1 and an information length K = N $\times$ r of the LDPC code;
a B matrix of a staircase structure adjacent to a right of the A matrix, of M1 rows and M1 columns;
a Z matrix that is a zero matrix adjacent to a right of the B matrix, of M1 rows and N - K - M1 columns;
a C matrix adjacent under the A matrix and the B matrix, of N - K - M1 rows and K + M1 columns; and
a D matrix that is an identity matrix adjacent to a right of the C matrix, of N - K - M1 rows and N - K - M1 columns,
the predetermined value M1 is 108,
the A matrix and the C matrix are represented by a parity check matrix initial value table,
the parity check matrix initial value table is a table representing positions of elements of 1 of the A matrix and the C matrix for every 36 columns, and

7 36 107 167 173 350 489 510 577 643 716 789 960 979 1061 1076
53 75 103 336 349 396 414 480 488 490 513 559 610 622 827 1039
13 69 101 108 122 277 483 532 546 587 612 710 713 858 982 1025
10 32 72 282 420 441 482 553 784 808 977
139 178 778 803 813 1055
130 576 709 732 827 991
109 125 403 905 998 1068.

**7.** A transmission device comprising

an encoding unit that performs LDPC coding on a basis of a parity check matrix of an LDPC code with a code length N of 1152 bits and a coding rate r of 144/1152,
wherein the parity check matrix includes:

an A matrix on an upper left of the parity check matrix, of M1 rows and K columns represented by a predetermined value M1 and an information length K = N × r of the LDPC code;
a B matrix of a staircase structure adjacent to a right of the A matrix, of M1 rows and M1 columns;
a Z matrix that is a zero matrix adjacent to a right of the B matrix, of M1 rows and N - K - M1 columns;
a C matrix adjacent under the A matrix and the B matrix, of N - K - M1 rows and K + M1 columns; and
a D matrix that is an identity matrix adjacent to a right of the C matrix, of N - K - M1 rows and N - K - M1 columns,
the predetermined value M1 is 144,
the A matrix and the C matrix are represented by a parity check matrix initial value table,
the parity check matrix initial value table is a table representing positions of elements of 1 of the A matrix and the C matrix for every 36 columns, and

9 70 143 150 170 202 349 475 620 732 806 1005
11 72 77 201 220 258 389 431 680 761 958
12 47 142 193 195 279 496 552 587 703 871
24 41 66 213 352 427 589 647 738 824 845
153 639 860 892 984
314 377 470 803 994
147 342 721 732 766
206 415 670 749 778.

8. The transmission device according to claim 7,
wherein the LDPC code is transmitted in an orthogonal frequency-division multiplexing (OFDM) segment partially receivable.

9. A transmission method comprising

an encoding step of performing LDPC coding on a basis of a parity check matrix of an LDPC code with a code length N of 1152 bits and a coding rate r of 144/1152,
wherein the parity check matrix includes:

an A matrix on an upper left of the parity check matrix, of M1 rows and K columns represented by a predetermined value M1 and an information length K = N × r of the LDPC code;
a B matrix of a staircase structure adjacent to a right of the A matrix, of M1 rows and M1 columns;
a Z matrix that is a zero matrix adjacent to a right of the B matrix, of M1 rows and N - K - M1 columns;
a C matrix adjacent under the A matrix and the B matrix, of N - K - M1 rows and K + M1 columns; and
a D matrix that is an identity matrix adjacent to a right of the C matrix, of N - K - M1 rows and N - K - M1 columns,
the predetermined value M1 is 144,
the A matrix and the C matrix are represented by a parity check matrix initial value table,
the parity check matrix initial value table is a table representing positions of elements of 1 of the A matrix and the C matrix for every 36 columns, and

9 70 143 150 170 202 349 475 620 732 806 1005
11 72 77 201 220 258 389 431 680 761 958
12 47 142 193 195 279 496 552 587 703 871
24 41 66 213 352 427 589 647 738 824 845
153 639 860 892 984
314 377 470 803 994
147 342 721 732 766
206 415 670 749 778.

10. A reception device comprising

a decoding unit that decodes an LDPC code obtained from data transmitted by a transmission method comprising an encoding step of performing LDPC coding on a basis of a parity check matrix of the LDPC code with a code length N of 1152 bits and a coding rate r of 144/1152,
wherein the parity check matrix includes:

an A matrix on an upper left of the parity check matrix, of M1 rows and K columns represented by a predetermined value M1 and an information length K = N × r of the LDPC code;
a B matrix of a staircase structure adjacent to a right of the A matrix, of M1 rows and M1 columns;
a Z matrix that is a zero matrix adjacent to a right of the B matrix, of M1 rows and N - K - M1 columns;
a C matrix adjacent under the A matrix and the B matrix, of N - K - M1 rows and K + M1 columns; and
a D matrix that is an identity matrix adjacent to a right of the C matrix, of N - K - M1 rows and N - K - M1 columns,
the predetermined value M1 is 144,
the A matrix and the C matrix are represented by a parity check matrix initial value table,
the parity check matrix initial value table is a table representing positions of elements of 1 of the A matrix and the C matrix for every 36 columns, and

9 70 143 150 170 202 349 475 620 732 806 1005
11 72 77 201 220 258 389 431 680 761 958
12 47 142 193 195 279 496 552 587 703 871
24 41 66 213 352 427 589 647 738 824 845
153 639 860 892 984
314 377 470 803 994
147 342 721 732 766
206 415 670 749 778.

**11.** The reception device according to claim 10,
wherein the LDPC code is transmitted in an orthogonal frequency-division multiplexing (OFDM) segment partially receivable.

**12.** A reception method comprising

a decoding step of decoding an LDPC code obtained from data transmitted by a transmission method comprising an encoding step of performing LDPC coding on a basis of a parity check matrix of the LDPC code with a code length N of 1152 bits and a coding rate r of 144/1152,
wherein the parity check matrix includes:

an A matrix on an upper left of the parity check matrix, of M1 rows and K columns represented by a predetermined value M1 and an information length K = N × r of the LDPC code;
a B matrix of a staircase structure adjacent to a right of the A matrix, of M1 rows and M1 columns;
a Z matrix that is a zero matrix adjacent to a right of the B matrix, of M1 rows and N - K - M1 columns;
a C matrix adjacent under the A matrix and the B matrix, of N - K - M1 rows and K + M1 columns; and
a D matrix that is an identity matrix adjacent to a right of the C matrix, of N - K - M1 rows and N - K - M1 columns,
the predetermined value M1 is 144,
the A matrix and the C matrix are represented by a parity check matrix initial value table,
the parity check matrix initial value table is a table representing positions of elements of 1 of the A matrix and the C matrix for every 36 columns, and

9 70 143 150 170 202 349 475 620 732 806 1005
11 72 77 201 220 258 389 431 680 761 958
12 47 142 193 195 279 496 552 587 703 871
24 41 66 213 352 427 589 647 738 824 845
153 639 860 892 984
314 377 470 803 994
147 342 721 732 766
206 415 670 749 778.

FIG. 1

13
TRANSMISSION DEVICE
COMMUNICATION PATH
RECEPTION DEVICE
11
12
TRANSMISSION SYSTEM

FIG. 2
11
TRANSMISSION DEVICE
21
ENCODING UNIT
31
L0 ENCODING UNIT
32
L1 ENCODING UNIT
22
DBPSK MODULATION UNIT
23
OFDM SIGNAL GENERATION UNIT
OFDM SIGNAL
TMCC, PILOT
MAIN DATA
L0 DATA
L1 DATA
LL DATA

OFDM SEGMENT
PARTIAL
RECEPTION POSSIBLE
FREQUENCY
TIME
OFDM SYMBOL
35 PIECES

FIG. 3

FIG. 4

H=
PARITY LENGTH M
PARITY MATRIX $H_T$
PARITY LENGTH M
INFORMATION LENGTH K
INFORMATION MATRIX $H_A$
CODE LENGTH N
PARITY CHECK MATRIX

FIG. 5

H_T =
1
1 1
1 1
0
0
1 1
1 1
1 1
PARITY MATRIX H_T

FIG. 6

INFORMATION MATRIX H_A
PARITY MATRIX H_T
PARITY CHECK MATRIX
X
COLUMN WEIGHT 3
COLUMN WEIGHT 2
1
M
KX
K3
M−1
1

FIG. 7

START
LDPC CODING
S101
DBPSK MODULATION
S102
OFDM SIGNAL GENERATION
S103
END

FIG. 8

START
GENERATE PARITY CHECK MATRIX USING PARITY CHECK MATRIX INITIAL VALUE TABLE
S111
ACQUIRE INFORMATION BITS
S112
PARITY CALCULATION USING INFORMATION BITS AND PARITY CHECK MATRIX
S113
END

# FIG. 9

DISPLAY ROW NUMBER OF PARITY CHECK MATRIX (INFORMATION MATRIX $H_A$) OF EVERY 360 COLUMN FROM FIRST COLUMN

ROW NUMBER OF PARITY CHECK MATRIX

FIRST COLUMN OF $H_A$ →
361st COLUMN OF $H_A$ →
721st COLUMN OF $H_A$ →
1081st COLUMN OF $H_A$ →

```
0 2084 1613 1548 1286 1460 3196 4297 2481 3369 3451 4620 2622
1 122 1516 3448 2880 1407 1847 3799 3529 373 971 4358 3108
2 259 3399 929 2650 864 3996 3833 107 5287 164 3125 2350
3 342 3529
4 4198 2147
5 1880 4836
6 3864 4910
7 243 1542
8 3011 1436
9 2167 2512
10 4606 1003
11 2835 705
12 3426 2365
13 3848 2474
14 1360 1743
0 163 2536
1 2583 1180
2 1542 509
3 4418 1005
4 5212 5117
5 2155 2922
6 347 2696
7 226 4296
8 1560 487
9 3926 1640
10 149 2928
11 2364 563
12 635 688
13 231 1684
14 1129 3894
```

$h_{3,5}$ (2650)

PARITY CHECK MATRIX INITIAL VALUE TABLE

FIG. 10

M
K
M1
M2=N−K−M1
A
B
Z
M1
M=N−K
C
D
M2

*FIG. 11*

2 6 18
2 10 19
22
19
15

M1
M1
K
P=5
Q1=3
A
B
ROW NUMBER
#0
#1
#2
#3
#4
#5
#6
#7
#8
#9
#10
#11
#12
#13
#14

FIG. 12

M1
K
A
B
ROW NUMBER
#0
#1
#2
#3
#4
#5
#6
#7
#8
#9
#10
#11
#12
#13
#14

FIG. 13

FIG. 14
ROW NUMBER
K
M1
M2
M1
M2
A
B
Z
C
D
Q2=2
#0
#1
#2
#3
#4
#5
#6
#7
#8
#9
#10
#11
#12
#13
#14
#15
#16
#17
#18
#19
#20
#21
#22
#23
#24

ROW NUMBER
#0
#1
#2
#3
#4
#5
#6
#7
#8
#9
#10
#11
#12
#13
#14
#15
#16
#17
#18
#19
#20
#21
#22
#23
#24
A
B
C
D
Z

FIG. 15

Z
B
D
A
C
ROW NUMBER
#0
#1
#2
#3
#4
#5
#6
#7
#8
#9
#10
#11
#12
#13
#14
#15
#16
#17
#18
#19
#20
#21
#22
#23
#24

FIG. 16

FIG. 17

Z
A
B
C
D
ROW NUMBER
#0
#1
#2
#3
#4
#5
#6
#7
#8
#9
#10
#11
#12
#13
#14
#15
#16
#17
#18
#19
#20
#21
#22
#23
#24

# FIG. 18

N=1224 BITS, r=144/1224

7 36 107 167 173 350 489 510 577 643 716 789 960 979 1061 1076
53 75 103 336 349 396 414 480 488 490 513 559 610 622 827 1039
13 69 101 108 122 277 483 532 546 587 612 710 713 858 982 1025
10 32 72 282 420 441 482 553 784 808 977
139 178 778 803 813 1055
130 576 709 732 827 991
109 125 403 905 998 1068

# FIG. 19

N=1152 BITS, r=144/1152

9 70 143 150 170 202 349 475 620 732 806 1005
11 72 77 201 220 258 389 431 680 761 958
12 47 142 193 195 279 496 552 587 703 871
24 41 66 213 352 427 589 647 738 824 845
153 639 860 892 984
314 377 470 803 994
147 342 721 732 766
206 415 670 749 778

VARIABLE NODE
EDGE
N PIECES
INTERLEAVER
EDGE
CHECK NODE
N/2 PIECES

FIG. 20

VARIABLE NODE
EDGE
EDGE
CHECK NODE
v 3 PIECES
v 2 PIECES
v 1 PIECES
c 3 PIECES
c 2 PIECES
c 1 PIECES
SECOND INTERLEAVER
FIRST INTERLEAVER

FIG. 21

COLUMN WEIGHT
COLUMN WEIGHT
M
K
M2
M1
M1-1
1
K3
K2
K1
0
Z
1
D
1
2
B
XM1
X3
X2
X1
A
C
M1
M2

FIG. 22

FIG. 23

| Rate | K | N | X1 | K1 | X2 | K2 | X3 | K3 | XM1 | M1 | M2 | P | Q1 | Q2 |
|---|---|---|---|---|---|---|---|---|---|---|---|---|---|---|
| 144/1224 | 144 | 1224 | 16 | 108 | 11 | 36 | 0 | 0 | 6 | 108 | 972 | 36 | 3 | 27 |
| 144/1152 | | 1152 | 12 | 36 | 11 | 108 | 0 | 0 | 5 | 144 | 864 | 36 | 4 | 24 |

P: PARALLEL FACTOR
Q1=M1/P
Q2=M2/P

FIG. 24

info
K
LDPC enc
N
DIFFERENTIAL CODING
N
BPSK map
N
channel
N
DIFFERENTIAL DEMODULATION
N
LDPC dec
K
COMPARE
BP
REPEAT 50 TIMES

FIG. 25
(N, K) = (1224, 144) LDPC code, iter=50, DBPSK, AWGN
FER
$10^{0}$
$10^{-1}$
$10^{-2}$
$10^{-3}$
$10^{-4}$
$10^{-5}$
CNR [dB]
−4.5
−4
−3.5
−3
−2.5
−2
−1.5
−1

FIG. 26
(N, K) = (1152, 144) LDPC code, iter=50, DBPSK, AWGN
FER
$10^0$
$10^{-1}$
$10^{-2}$
$10^{-3}$
$10^{-4}$
$10^{-5}$
CNR [dB]
−4.5
−4
−3.5
−3
−2.5
−2
−1.5
−1

# FIG. 27

12
RECEPTION DEVICE
OFDM SIGNAL
61
OFDM DEMODULATION UNIT
62
LL EXTRACTION UNIT
63
DIFFERENTIAL DEMODULATION UNIT
64
DECODING UNIT
LL DATA
(L0 DATA, L1 DATA)

FIG. 28

START
DEMODULATE OFDM SIGNAL
S201
EXTRACT L0 CARRIER AND L1 CARRIER
S202
DIFFERENTIAL DEMODULATE L0 CARRIER AND L1 CARRIER
S203
LDPC DECODING
S204
END

FIG. 29

H =

H' =

FIG. 30

FIG. 31

FIG. 32

FROM COMMUNICATION PATH
D313
310
RECEPTION DATA REARRANGEMENT UNIT
D314
RECEPTION LLR
306
NEXT IF EACH FIFO GETS EMPTY
D309
309
311
DECODED DATA REARRANGEMENT UNIT
DECODING RESULT
D315
D316
304
D307
Matrix DATA
300
NEXT IF EACH FIFO GETS EMPTY
D301
D312
Matrix DATA
D305
CYCLIC SHIFT CIRCUIT
D302
D303
303
D304
302
301
D308
307
D310
CYCLIC SHIFT CIRCUIT
308
305
D311

FIG. 33
FROM COMMUNICATION PATH
D313
RECEPTION LLR
306
NEXT IF EACH FIFO GETS EMPTY
D307
D309
309
311
DECODED DATA REARRANGEMENT UNIT
DECODING RESULT
D315
D316
304
D306
Matrix DATA
D305
D304
CYCLIC SHIFT CIRCUIT
303
D303
302
D302
301
NEXT IF EACH FIFO GETS EMPTY
D301
300
Matrix DATA
D312
D300
305
D308
307
D310
CYCLIC SHIFT CIRCUIT
308
D311

FIG. 34

702
CPU
703
ROM
704
RAM
705
HARD DISK
701
INPUT/OUTPUT INTERFACE
710
OUTPUT UNIT
706
INPUT UNIT
707
COMMUNICATION UNIT
708
DRIVE
709
REMOVABLE RECORDING MEDIUM
711
COMPUTER

**INTERNATIONAL SEARCH REPORT**

International application No.
**PCT/JP2022/039359**

**A. CLASSIFICATION OF SUBJECT MATTER**

***H03M 13/19***(2006.01)i; ***H04L 27/26***(2006.01)i
FI: H03M13/19; H04L27/26 110

According to International Patent Classification (IPC) or to both national classification and IPC

**B. FIELDS SEARCHED**

Minimum documentation searched (classification system followed by classification symbols)

H03M13/19; H04L27/26

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2021-93727 A (NIPPON HOSO KYOKAI <NHK>) 17 June 2021 (2021-06-17) | 1-12 |
| A | WO 2019/142686 A1 (SONY CORP.) 25 July 2019 (2019-07-25) | 1-12 |
| A | JP 2021-136486 A (NIPPON HOSO KYOKAI (NHK)) 13 September 2021 (2021-09-13) | 1-12 |

☐ Further documents are listed in the continuation of Box C.
☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **13 December 2022** | **20 December 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/039359**

| Patent document cited in search report | Publication date (day/month/year) | Patent family member(s) | Publication date (day/month/year) |
|---|---|---|---|
| JP 2021-93727 A | 17 June 2021 | (Family: none) | |
| WO 2019/142686 A1 | 25 July 2019 | JP 2019-125952 A<br>EP 3742619 A1<br>KR 10-2020-0108832 A | |
| JP 2021-136486 A | 13 September 2021 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 4224777 B


### Non-patent literature cited in the description


- *ATSC Standard: Physical Layer Protocol (A/322),* 07 September 2016
- **S. Y. CHUNG ; G. D. FORNEY ; T. J. RICHARDSON ; R. URBANKE.** On the Design of Low-Density Parity-Check Codes within 0.0045 dB of the Shannon Limit. *IEEE Communications Leggers,* February 2001, vol. 5 (2